# EUROPEAN PATENT APPLICATION

(11) **EP 3 839 935 A1**
(43) Date of publication of application: **23.06.2021**
(21) Application number: 18935066.3
(22) Date of filing: 28.09.2018
(51) Int. Cl.: G09G 3/36

(54) **GATE DRIVE CIRCUIT AND CONTROL METHOD THEREFOR, AND MOBILE TERMINAL**

(71) Applicant: HUAWEI TECHNOLOGIES CO., LTD., Shenzhen, Guangdong 518129 (CN)
(72) Inventor: LIU, Chun Yen, Shenzhen, Guangdong 518129 (CN); WAI, Dustin Yuk Lun, Shenzhen, Guangdong 518129 (CN)
(74) Representative: Pfenning, Meinig & Partner mbB
(86) International application number: PCT/CN2018/108489
(87) International publication number: WO 2020/062103

(57) **Abstract**

Embodiments of this application relate to the field of display technologies, and provide a gate driving circuit, a method for controlling a gate driving circuit, and a mobile terminal, to resolve a problem that a complete image cannot be displayed after a flexible display screen is folded. The gate driving circuit includes a first driving group, a first connection controller, and a second driving group. The first driving group is configured to receive a start signal output by a first signal end of a display driver. A first end of the first connection controller is configured to receive an active signal output by the first driving group. A second end of the first connection controller is configured to receive a cascade gating signal output by a second signal end of the display driver. A third end of the first connection controller is configured to receive a split-screen gating signal output by a third signal end of the display driver. A fourth end of the first connection controller is configured to receive a split-screen display signal output by a fourth signal end of the display driver. The second driving group is configured to receive an active signal output by a fifth end of the first connection controller.

## Description

### TECHNICAL FIELD

This application relates to the field of display technologies, and in particular, to a gate driving circuit, a method for controlling a gate driving circuit, and a mobile terminal.

### BACKGROUND

With development of electronic device technologies, a size of a display screen of a mobile terminal, for example, a mobile phone, has relatively great impact on a display effect. To make a display image clearer and more vivid, the size of the display screen of the mobile phone continuously increases. However, a mobile phone with a relatively large screen size has relatively poor portability. To resolve the foregoing problem, a bendable flexible display screen (flexible display screen) is proposed. A user can bend the display screen as needed, thereby improving portability of the mobile phone.

However, after the flexible display screen is folded, the user can view only a part of a display image, and a complete image cannot be displayed on the folded display screen as needed.

### SUMMARY

Embodiments of this application provide a gate driving circuit, a method for controlling a gate driving circuit, and a mobile terminal, to resolve a problem that a complete image cannot be displayed after a flexible display screen is folded.

To achieve the foregoing objective, the following technical solutions are used in this application:

According to a first aspect of the embodiments of this application, a gate driving circuit is provided, where the gate driving circuit is configured to drive a pixel circuit on a display panel to perform displaying. The gate driving circuit includes a first driving group, a first connection controller, and a second driving group. The first driving group includes M cascaded shift registers, and an input end of the first driving group is electrically connected to a first signal end of a display driver, to receive a start signal output by the first signal end of the display driver, where M ≥ 2, and M is a positive integer. A first end of the first connection controller is electrically connected to an output end of the first driving group, to receive an active signal output by the first driving group. A second end of the first connection controller is electrically connected to a second signal end of the display driver, to receive a cascade gating signal output by the second signal end of the display driver. A third end of the first connection controller is electrically connected to a third signal end of the display driver, to receive a split-screen gating signal output by the third signal end of the display driver. A fourth end of the first connection controller is electrically connected to a fourth signal end of the display driver, to receive a split-screen display signal output by the fourth signal end of the display driver. The second driving group includes N cascaded shift registers, and an input end of the second driving group is electrically connected to a fifth end of the first connection controller, to receive an active signal output by the fifth end of the first connection controller, where N ≥ 2, and N is a positive integer. Based on this, a mobile terminal having the foregoing gate driving circuit includes a first pixel circuit and a second pixel circuit that are configured to display an image. The first driving group may independently drive a display subarea that includes only a plurality of first pixel circuits. The second driving group may independently drive a display subarea that includes only a plurality of second pixel circuits. In this case, the first connection controller may cascade the shift registers in the first driving group and the second driving group that are adjacent to each other, so that after the cascading, the two adjacent display subareas respectively controlled by the first driving group and the second driving group that are adjacent to each other jointly display a same image in a same image frame. Alternatively, the first connection controller may disconnect a path between the first driving group and the second driving group that are adjacent to each other. The first connection controller controls the display subarea connected to the second driving group to independently display an image.

Optionally, the gate driving circuit further includes a second connection controller and a third driving group. A first end of the second connection controller is electrically connected to an output end of the second driving group, to receive an active signal output by the second driving group. A second end of the second connection controller is electrically connected to the second signal end of the display driver, to receive the cascade gating signal output by the second signal end of the display driver. A third end of the second connection controller is electrically connected to the third signal end of the display driver, to receive the split-screen gating signal output by the third signal end of the display driver. A fourth end of the second connection controller is electrically connected to the fourth signal end of the display driver, to receive the split-screen display signal output by the fourth signal end of the display driver. In addition, the third driving group includes S cascaded shift registers, and an input end of the third driving group is electrically connected to a fifth end of the second connection controller, to receive an active signal output by the fifth end of the second connection controller, where S ≥ 2, and S is a positive integer. Based on this, the mobile terminal having the foregoing gate driving circuit includes the first pixel circuit, the second pixel circuit, and a third pixel circuit that are configured to display an image. The first driving group may independently drive a display subarea that includes only a plurality of first pixel circuits. The second driving group may independently drive a display subarea that includes only a plurality of second pixel circuits. The third driving group may independently drive a display subarea that includes only a plurality of third pixel circuits. In this case, the first connection controller may cascade the shift registers in the first driving group and the second driving group that are adjacent to each other. The second connection controller may cascade the shift registers in the second driving group and the third driving group that are adjacent to each other. After the cascading, three adjacent display subareas respectively controlled by the first driving group, the second driving group, and the third driving group that are adjacent to each other jointly display a same image in a same image frame. Alternatively, the first connection controller may disconnect the path between the first driving group and the second driving group that are adjacent to each other, and the second connection controller may disconnect a path between the second driving group and the third driving group that are adjacent to each other. The first connection controller controls the display subarea connected to the second driving group to independently display an image. The second connection controller controls a display subarea connected to the third driving group to independently display an image.

Optionally, the first connection controller includes a first switch and a second switch. The first switch is electrically connected to the second signal end of the display driver, the output end of the first driving group, and the input end of the second driving group. The first switch is configured to receive the cascade gating signal output by the second signal end of the display driver and is enabled or disabled under control of the cascade gating signal, and in the enabled state, transmits, to the input end of the second driving group, the received active signal that is output by the output end of the first driving group. In this way, cascading between or disconnection of the path between the first driving group and the second driving group can be controlled by controlling enablement or disablement of the first switch. In addition, the second switch is electrically connected to the third signal end of the display driver, the fourth signal end of the display driver, and the input end of the second driving group. The second switch is configured to receive the split-screen gating signal output by the third signal end of the display driver and is enabled or disabled under control of the split-screen gating signal, and in the enabled state, transmits, to the input end of the second driving group, the received split-screen display signal that is output by the fourth signal end of the display driver. In this way, a display subarea connected to the second driving group can be controlled, by controlling enablement or disablement of the second switch, to independtly display an image or to stay in a screen-off state.

Optionally, the first switch includes a first transistor. A gate of the first transistor is electrically connected to the second signal end of the display driver, a first electrode of the first transistor is electrically connected to the output end of the first driving group, and a second electrode of the first transistor is electrically connected to the input end of the second driving group. In this way, enablement and disablement of the first switch can be controlled by controlling a voltage that is input to the gate of the first transistor. In addition, the second switch includes a second transistor. A gate of the second transistor is electrically connected to the third signal end of the display driver, a first electrode of the second transistor is electrically connected to the fourth signal end of the display driver, and a second electrode of the second transistor is electrically connected to the input end of the second driving group. In this way, enablement and disablement of the second switch can be controlled by controlling a size of a voltage that is input to the gate of the second transistor.

Optionally, in the first driving group or the second driving group, in a plurality of shift registers other than a first-level shift register, a signal output end of an upper-level shift register is electrically connected to a signal input end of a lower-level shift register. On such a basis, the first electrode of the first transistor is electrically connected to a signal output end of a last-level shift register in the first driving group, and the second electrode of the first transistor is electrically connected to a signal input end of the first-level shift register in the second driving group. The second electrode of the second transistor is electrically connected to the signal input end of the first-level shift register in the second driving group. In this way, only one first connection controller needs to be disposed between the first driving group and the second driving group.

According to another aspect of the embodiments of this application, a mobile terminal is provided. The mobile terminal includes at least one of any gate driving circuit described above. The mobile terminal further includes a first pixel circuit and a second pixel circuit that are configured to display an image. In a first driving group of the gate driving circuit, a signal output end of each level of shift register is electrically connected to gates of some transistors in the first pixel circuit. In a second driving group of the gate driving circuit, a signal output end of each level of shift register is electrically connected to gates of some transistors in the second pixel circuit. The mobile terminal has same technical effects as the gate driving circuit provided in the foregoing embodiment. Details are not described herein again.

Optionally, the pixel circuits each include a light emitting component and a light emitting control transistor that is in a turned-on state when the light emitting component emits light. In the first driving group, a signal output end of each level of shift register is electrically connected to a gate of the light emitting control transistor in the first pixel circuit. In the second driving group, a signal output end of each level of shift register is electrically connected to a gate of the light emitting control transistor in the second pixel circuit. Under control of a light emitting control signal, a driving current generated by a driving transistor in the first pixel circuit or the second pixel circuit is transmitted to the light emitting component, to drive the light emitting component to emit light, so that a sub pixel having the first pixel circuit or the second pixel circuit performs displaying. Therefore, the light emitting control signal is mainly used to control the sub pixel to perform displaying. Therefore, to enable each display subarea in a display panel to perform displaying independently, the first driving group and the second driving group in the gate driving circuit are connected to a gate of a light emitting transistor in the sub pixel.

Optionally, the mobile terminal includes two gate driving circuits, which are respectively a first gate driving circuit and a second gate driving circuit. In the first gate driving circuit, a signal output end of each level of shift register in each first driving group is electrically connected to gates of some transistors in a first pixel circuit in an odd-numbered row or column; and a signal output end of each level of shift register in each second driving group is electrically connected to gates of some transistors in a second pixel circuit in an odd-numbered row or column. In the second gate driving circuit, a signal output end of each level of shift register in each first driving group is electrically connected to gates of some transistors in the first pixel circuit in an even-numbered row or column; and a signal output end of each level of shift register in each second driving group is electrically connected to gates of some transistors in the second pixel circuit in an even-numbered row or column. In this way, the first gate driving circuit and the second gate driving circuit can be used to respectively drive sub pixels in the odd-numbered row (or column) and the even-numbered row (or column).

Optionally, a display driver includes a display driver integrated circuit, and the display driver integrated circuit includes a first signal end, a second signal end, a third signal end, and a fourth signal end. The first signal end is configured to send a start signal. The second signal end is configured to send a cascade gating signal. The third signal end is configured to send a split-screen gating signal. The fourth signal end is configured to send a split-screen display signal. In this case, after the gate driving circuits are connected to the display driver integrated circuit, the display driver integrated circuit may provide the start signal for a first-level shift register by using the first signal end, and provide the cascade gating signal, the split-screen gating signal, and the split-screen display signal for a first connection controller.

Optionally, the mobile terminal further includes an underlying substrate. The first pixel circuit and the second pixel circuit are fabricated on the underlying substrate. In addition, a material constituting the underlying substrate includes a flexible resin material. In this case, the display panel of the mobile terminal is a bendable flexible display substrate.

According to another aspect of the embodiments of this application, a method for controlling a gate driving circuit is provided. The gate driving circuit includes a first driving group, a first connection controller, and a second driving group. The first driving group includes M cascaded shift registers, and an input end of the first driving group is electrically connected to a first signal end of a display driver, where M ≥ 2, and M is a positive integer. A first end of the first connection controller is electrically connected to an output end of the first driving group. A second end of the first connection controller is electrically connected to a second signal end of the display driver. A third end of the first connection controller is electrically connected to a third signal end of the display driver. A fourth end of the first connection controller is electrically connected to a fourth signal end of the display driver. The second driving group includes N cascaded shift registers, and an input end of the second driving group is electrically connected to a fifth end of the first connection controller, where N ≥ 2, and N is a positive integer. In addition, the first connection controller includes a first switch and a second switch. The first switch is electrically connected to the second signal end of the display driver, the output end of the first driving group, and the input end of the second driving group. The second switch is electrically connected to the third signal end of the display driver, the fourth signal end of the display driver, and the input end of the second driving group. In this case, the method for controlling a gate driving circuit includes: first, receiving, by the first switch, an inactive cascade gating signal output by the second signal end of the display driver, so that the first switch is disabled and a path between the first driving group and the second driving group is disconnected; next, receiving, by the second switch, an active split-screen gating signal output by the third signal end of the display driver, so that the second switch is enabled; and next, receiving, by the second switch, an active split-screen display signal output by the fourth signal end of the display driver, where the active split-screen display signal is output to the input end of the second driving group through the enabled second switch, and signal output ends of the N shift registers in the second driving group output a gate driving signal in sequence; or receiving, by the second switch, an inactive split-screen display signal end output by the fourth signal end of the display driver, where the inactive split-screen display signal is output to the input end of the second driving group through the enabled second switch, and signal output ends of all the shift registers in the second driving group output a non-gate driving signal.

Optionally, the method further includes: receiving, by the input end of the first driving group, an active start signal output by the first signal end of the display driver, where signal output ends of all levels of shift registers in the first driving group output a gate driving signal in sequence. In this case, after signal output ends of all shift registers in the second driving group output a non-gate driving signal, a display subarea controlled by the first driving group and a display subarea controlled by the second driving group may respectively display a first image and a second image.

### BRIEF DESCRIPTION OF DRAWINGS

FIG. 1 is a schematic structural diagram of a display panel according to some embodiments of this application;
FIG. 2 is a schematic structural diagram of a pixel circuit and a gate driving circuit in FIG. 1;
FIG. 3 is a schematic structural diagram of another pixel circuit in FIG. 1;
FIG. 4 is a control flowchart of each signal end in the pixel circuit shown in FIG. 3;
FIG. 5 is a schematic structural diagram of a mobile terminal according to some embodiments of this application;
FIG. 6A and FIG. 6B are a schematic structural diagram of a pixel circuit and a gate driving circuit in FIG. 1, where the gate driving circuit is, for example, a light emitting driving circuit;
FIG. 7a is a schematic structural diagram of another mobile terminal according to some embodiments of this application;
FIG. 7b is a schematic structural diagram of another mobile terminal according to some embodiments of this application;
FIG. 7c is a schematic structural diagram of another mobile terminal according to some embodiments of this application;
FIG. 8 is a schematic structural diagram of another mobile terminal according to some embodiments of this application;
FIG. 9A and FIG. 9B are a schematic structural diagram of a gate driving circuit in FIG. 7b or FIG. 8;
FIG. 10 is a schematic structural diagram of another gate driving circuit in FIG. 7b or FIG. 8;
FIG. 11 is a schematic diagram of division of display subareas on a mobile terminal according to some embodiments of this application;
FIG. 12 is a schematic diagram of one type of image display on the mobile terminal shown in FIG. 11;
FIG. 13a is a schematic diagram of another type of image display on the mobile terminal shown in FIG. 11;
FIG. 13b is a schematic structural diagram of the mobile terminal shown in FIG. 13a after the mobile terminal is bent;
FIG. 14 is a schematic diagram of division of display subareas on another mobile terminal according to some embodiments of this application;
FIG. 15 is a schematic diagram of one type of image display on the mobile terminal shown in FIG. 11;
FIG. 16a is a schematic diagram of a bending state of the mobile terminal shown in FIG. 15;
FIG. 16b is a schematic structural diagram of the mobile terminal shown in FIG. 16a after the mobile terminal is bent;
FIG. 17 is a schematic diagram of a bending state of the mobile terminal shown in FIG. 11;
FIG. 18a is a schematic diagram of another bending state of the mobile terminal shown in FIG. 11;
FIG. 18b is a schematic diagram of another bending state of the mobile terminal shown in FIG. 11;
FIG. 19 is a schematic diagram of another bending state of the mobile terminal shown in FIG. 11;
FIG. 20 is a schematic structural diagram of a gate driving circuit according to an embodiment of this application; and
FIG. 21 is a flowchart of a method for controlling a gate driving circuit according to an embodiment of this application.

### Reference numerals:

01: gate driving circuit; 10: display panel; 100: active display area; 101: non-display area; 20: sub pixel; 201: pixel circuit; 11: driving group; and 12: connection controller.

### DESCRIPTION OF EMBODIMENTS

The following describes the technical solutions in the embodiments of this application with reference to the accompanying drawings of the embodiments of this application. Apparently, the described embodiments are merely some but not all of the embodiments of this application.

The terms such as "first" and "second" below are merely for a descriptive purpose, and cannot be understood as indicating or implying relative importance, or implicitly indicating a quantity of indicated technical features. Therefore, the features defined by "first" and "second" can explicitly or implicitly include one or more features.

In addition, in this application, terms of direction such as "upper", "lower", "left", "right", "horizontal", and "vertical" are defined relative to an illustrated placement position of a component in an accompanying drawing. It should be understood that these directional terms are relative concepts and are used to describe and clarify relativity, and may be changed accordingly as a placement position of the component in the accompanying drawing changes.

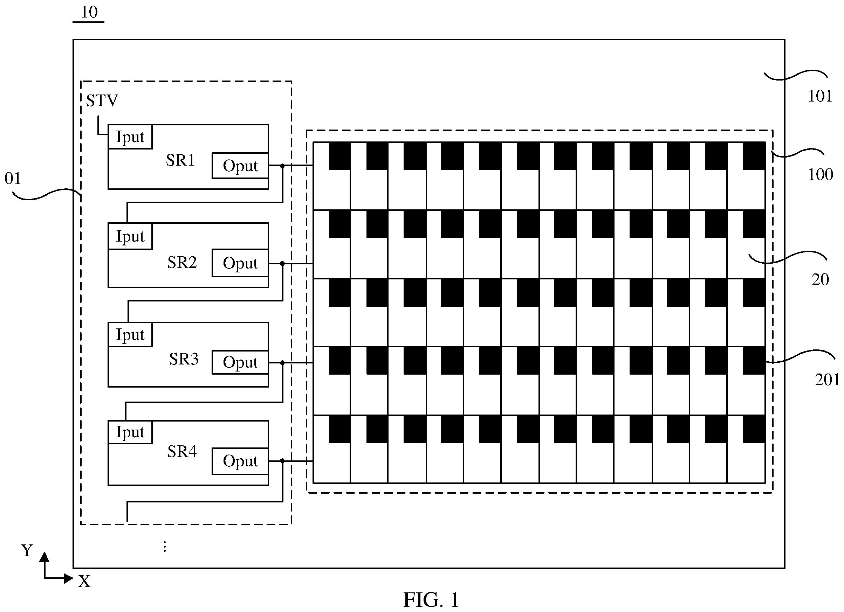

Some embodiments of this application provide a gate driving circuit 01 (as shown in FIG. 1). The gate driving circuit 01 may use a gate driver on array (Gate Driver on Array, GOA) technology, and the gate driving circuit 01 is fabricated on an underlying substrate of a display panel. The gate driving circuit is configured to drive a pixel circuit on the display panel to perform displaying.

Some embodiments of this application provide a mobile terminal. The gate driving circuit 01 may be applied to the mobile terminal, for example, including a mobile phone, a tablet computer, a personal digital assistant (personal digital assistant, PDA), or an in-vehicle computer. A specific form of the mobile terminal is not particularly limited in the embodiments of this application.

The mobile terminal includes a display panel 10 shown in FIG. 1. The display panel 10 includes an active display area (active area, AA) 100 and a non-display area 101 that is located in a periphery of the active display area 100.

The active display area 100 includes a plurality of sub pixels (sub pixel) 20. For ease of description, in this application, descriptions are provided by using an example in which the plurality of sub pixels 20 are arranged in a form of a matrix. In this case, sub pixels 20 arranged in a line in a horizontal direction X are referred to as sub pixels in a same row, and sub pixels 20 arranged in a line in a vertical direction Y are referred to as sub pixels in a same column. A pixel circuit 201 that is configured to control a sub pixel 20 to perform displaying is disposed in the sub pixel 20. The pixel circuit 201 includes a plurality of transistors.

In addition, as shown in FIG. 1, the gate driving circuit 01 is disposed in the non-display area 101. The gate driving circuit 01 includes a plurality of shift registers (shift register, SR for short). A signal output end (OUTput, Oput for short) of each shift register SR can provide a gate driving signal for a gate of at least one transistor in a row of sub pixels 20.

In this case, when a plurality of shift registers SRs are cascaded in sequence, for example, as shown in FIG. 1, a signal output end Oput of a first-level shift register SR1 is connected to a signal input end (INput, Iput for short) of a second-level shift register SR2. The second-level shift register SR2 is adjacent to the first-level shift register SR1.

A signal output end Oput of the second-level shift register SR2 is connected to a signal input end Iput of a third-level shift register SR3. The third-level shift register SR3 is adjacent to the second-level shift register SR2.

In addition, a manner of cascading other shift registers SRs is the same as the manner described above.

A signal input end Iput of the first-level shift register SR1 is configured to receive a start signal (start vertical frame signal, STV for short). When the start signal STV is at a high voltage (High voltage), the start signal STV is an active signal, and the first-level shift register SR1 is started.

When the start signal STV is at a low voltage (low voltage), the start signal STV is an inactive signal, and in this case, the first-level shift register SR1 does not work.

Based on this, the first-level shift register SR1 provides a gate driving signal for a gate of a transistor that is in a first row of sub pixels 20 and that is connected to the signal output end Oput of the first-level shift register SR1. In addition, the first-level shift register SR1 further provides a start signal for the signal input end Iput of the second-level shift register SR2, to start the second-level shift register SR2.

Next, the second-level shift register SR2 provides a gate driving signal for a gate of a transistor that is in a second row of sub pixels 20 and that is connected to the signal output end Oput of the second-level shift register SR2. In addition, the second-level shift register SR2 further provides a start signal for the signal input end Iput of the third-level shift register SR3, to start the third-level shift register SR3.

Next, the third-level shift register SR3 provides a gate driving signal for a gate of a transistor that is in a third row of sub pixels 20 and that is connected to a signal output end Oput of the third-level shift register SR3. In addition, the third-level shift register SR3 further provides a start signal for a signal input end Iput of one level of shift register cascaded to the third-level shift register SR3. In this way, by using the foregoing plurality of cascaded shift registers SRs, a plurality of rows of sub pixels 20 arranged in sequence may be scanned row by row.

It should be noted that all the foregoing descriptions are provided by using an example in which one level of shift register SR in the gate driving circuit 01 controls one row (or column) of sub pixels 20 to perform displaying. In some other embodiments of this application, the one level of shift register SR may alternatively control at least two rows (or columns) of sub pixels 20 to perform displaying. An internal structure of the shift register SR is not limited in the embodiments of this application.

The following illustrates a pixel circuit 201 in a sub pixel 20.

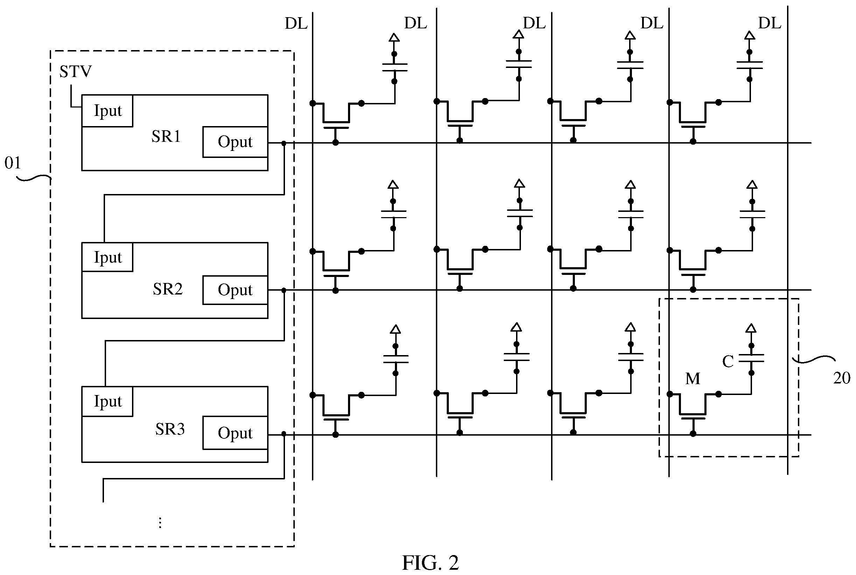

For example, when the display panel 10 is a liquid crystal display panel, as shown in FIG. 2, a pixel circuit 201 includes a transistor M and a liquid crystal capacitor C. Two plates of the liquid crystal capacitor C are respectively a pixel electrode and a common electrode. In this case, a gate of the transistor M may be connected to a signal output end Oput of one level of shift register SR in the gate driving circuit 01.

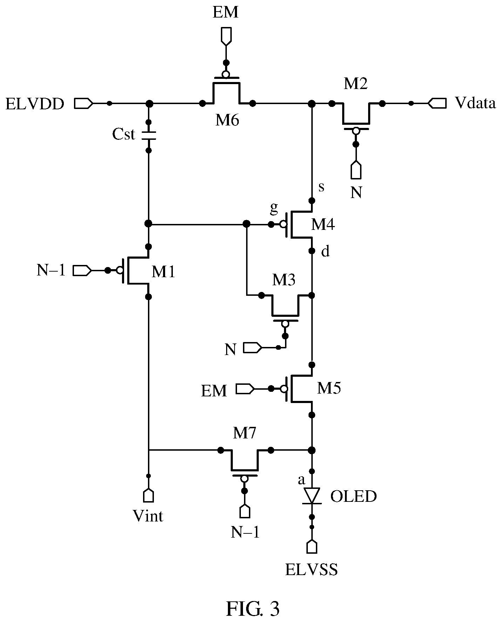

Alternatively, for another example, when the display panel 10 is a light emitting diode display panel or an organic light emitting diode (organic light emitting diode, OLED) display panel, as shown in FIG. 3, a pixel circuit 201 in a sub pixel 20 may include a capacitor C, a plurality of switch transistors (M1, M2, M3, M5, M6, and M7), and one driving transistor M4.

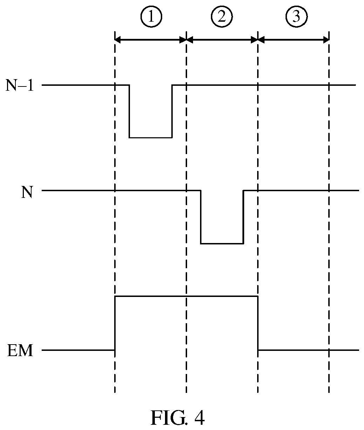

Gates of some switch transistors (for example, M1 and M7) are configured to receive a first gating signal N-1 shown in FIG. 4. Gates of some other switch transistors (for example, M2 and M3) are configured to receive a second gating signal N shown in FIG. 4. Gates of still some other switch transistors (for example, M5 and M6) are configured to receive a light emitting control signal EM shown in FIG. 4.

It should be noted that a working process of a pixel circuit shown in FIG. 3 includes three stages shown in FIG. 4: stage (1), stage (2), and stage (3).

At stage (1), the transistor M1 and the transistor M7 in FIG. 3 are turned on under control of the first gating signal N-1. An initial voltage Vint is separately transmitted to a gate (gate, g for short) of the driving transistor M4 and an anode (anode, a for short) of the OLED via the transistor M1 and the transistor M7, to reset the anode a of the OLED and the gate g of the driving transistor M4.

At stage (2), under control of the second gating signal N, the transistor M2 is turned on, the gate g and a drain (drain, d for short) of the driving transistor M4 are electrically connected, and the driving transistor M4 is in a diode-on state. In this case, a data signal Vdata is written into a source (source, s for short) of the driving transistor M4 via the transistor M2, and a threshold voltage Vth of the driving transistor M4 is compensated.

At stage (3), under control of the light emitting control signal EM, the transistor M5 and the transistor M6 are turned on, and a current path between voltages ELVDD and ELVSS is turned on. A driving current Isd generated by the driving transistor M4 is transmitted to the OLED through the current path, to drive the OLED to emit light.

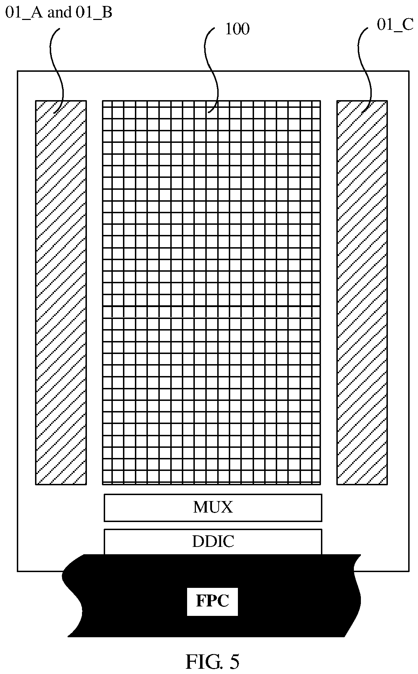

In this case, as shown in FIG. 5, three gate driving circuits 01 are disposed in the non-display area 101 of the display panel 10, and are respectively a gate driving circuit 01_A configured to emit the first gating signal N-1, a gate driving circuit 01_B configured to emit the second gating signal N, and a gate driving circuit 01_C configured to emit the light emitting control signal EM.

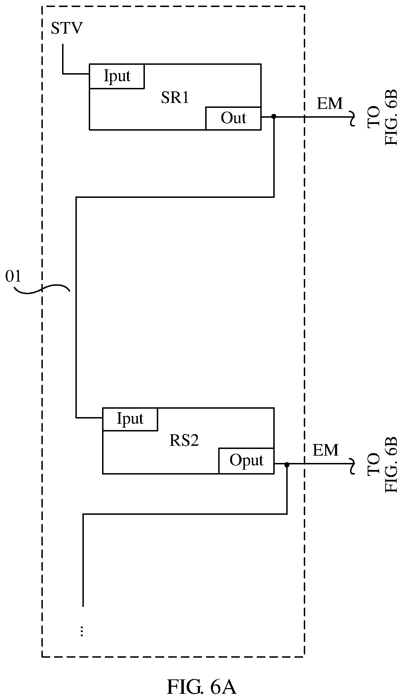

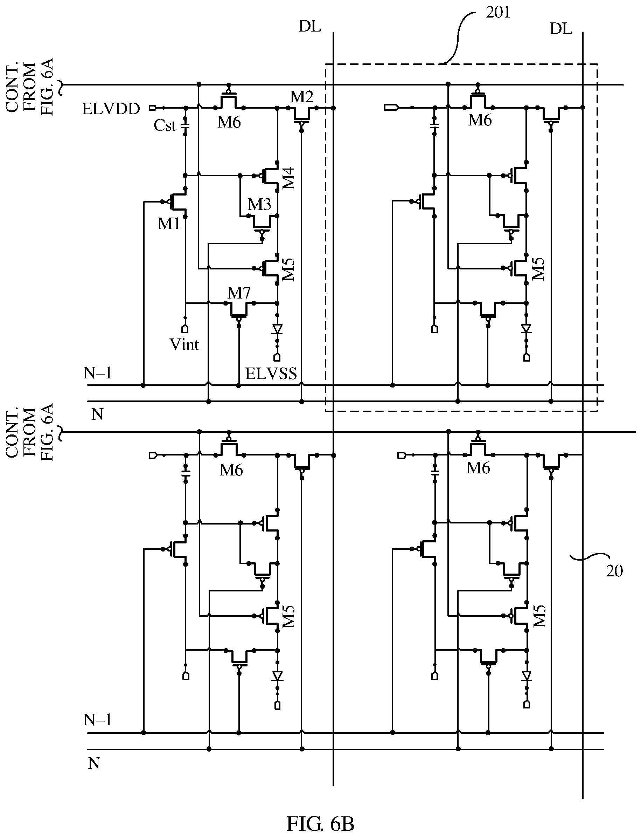

Based on this, as shown in FIG. 6A and FIG. 6B, in each pixel circuit 201 of a same row of sub pixels 20, gates of switch transistors M5 and M6 may be connected to a signal output end Oput of one level of shift register SR in a gate driving circuit 01_C.

In addition, it can be learned by analogy that the gates of the switch transistors M1 and M7 may be connected to a signal output end Oput of one level of shift register SR in the gate driving circuit 01_A. The gates of the switch transistors M2 and M3 may be connected to a signal output end Oput of one level of shift register SR in the gate driving circuit 01_B.

It can be learned from the foregoing description that because the plurality of shift registers SRs in the gate driving circuit 01 are cascaded in sequence, in a same image frame, the shift registers SRs in the gate driving circuit 01 output a gate driving signal in sequence by using their respective signal output ends Oput. In this case, after the first row of sub pixels 20 is scanned, other rows of sub pixels 20 are also scanned row by row, so that all the sub pixels 20 in the entire active display area 100 jointly display a same image frame. However, in this way, shift registers SRs other than the first-level shift register SR1 in the gate driving circuit 01 can be started only after receiving an active signal provided by a signal output end Oput of an upper-level shift register SR, and cannot receive the start signal STV directly. Therefore, a user cannot control some zones of the active display area 100 to display an image independently.

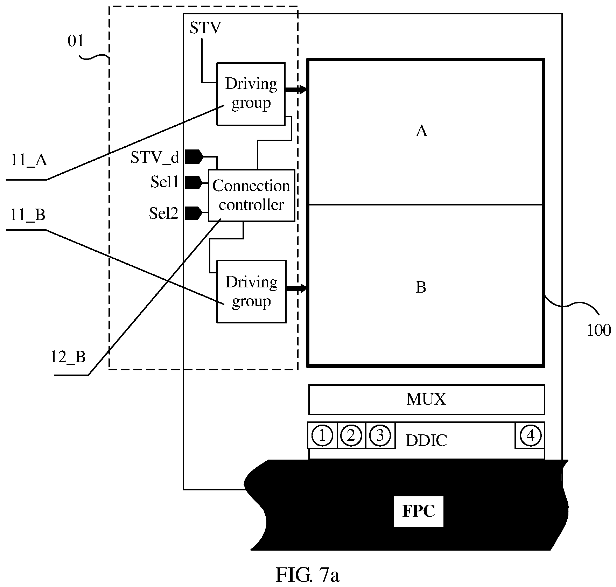

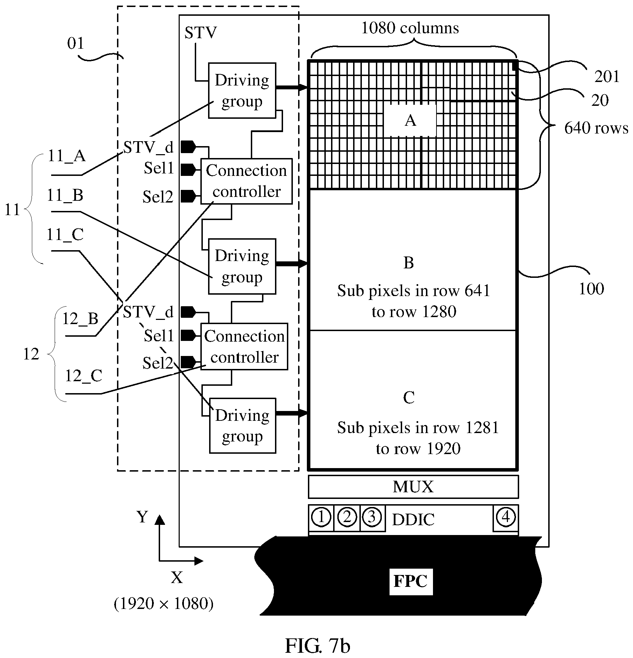

To resolve the foregoing problem, that is, to enable a part of the active display area 100 to display a complete image to achieve zone-based independent display, in some embodiments of this application, as shown in FIG. 7a, the active display area 100 of the display panel 10 may be divided into a plurality of display subareas, for example, a display subarea A and a display subarea B. Alternatively, as shown in FIG. 7b, the active display area 100 of the display panel 10 is divided into a display subarea A, a display subarea B, and a display subarea C.

Based on this, a plurality of adjacent shift registers SRs in the gate driving circuit 01 that are cascaded in sequence form one driving group 11. Any shift register SR belongs to only one driving group 11.

Pixel circuits 201 in sub pixels 20 in a same display subarea are connected to a same driving group 11, so that each driving group 11 can independently control one display subarea to perform displaying independently.

The gate driving circuit 01 is connected to a display driver disposed in the non-display area 101 of the display panel 10. In some embodiments of this disclosure, the display driver may be a display driver integrated circuit (display driver integrated circuits, DDIC) shown in FIG. 7a or FIG. 7b. The gate driving circuit 01 is connected to a first signal end (1), a second signal end (2), a third signal end (3), and a fourth signal end (4) of the DDIC.

The first signal end (1) of the DDIC is configured to provide a start signal STV for the gate driving circuit 01. The second signal end (2) of the DDIC is configured to provide a cascade gating signal Sell for the gate driving circuit 01. The third signal end (3) of the DDIC is configured to provide a split-screen gating signal Sel2 for the gate driving circuit 01. The fourth signal end (4) of the DDIC is configured to provide a split-screen display signal STV_d for the gate driving circuit 01.

In addition, as shown in FIG. 7a or FIG. 7b, a plurality of multiplexers (multiplexer, MUX) are further disposed in the non-display area 101 of the display panel 10. One MUX is configured to electrically connect a plurality of data lines (data line, DL) and the DDIC.

It should be noted that for ease of illustration, all the following descriptions are provided by using an example in which the display driver is a DDIC.

Based on this, using the structure shown in FIG. 7a as an example, the gate driving circuit 01 includes a first driving group such as a driving group 11_A in FIG. 7a, a second driving group such as a driving group 11_B in FIG. 7a, and a first connection controller such as a connection controller 12_B.

In this case, the mobile terminal further includes a first pixel circuit and a second pixel circuit that are configured to display an image. The first pixel circuit is located in the display subarea A, and the second pixel circuit is located in the display subarea B.

In the first driving group (driving group 11_A) of the gate driving circuit 01, a signal output end of each level of shift register SR is electrically connected to gates of some transistors in the first pixel circuit, so that the driving group 11_A independently controls the display subarea A.

In the second driving group (driving group 11_B) of the gate driving circuit 02, a signal output end of each level of shift register SR is electrically connected to gates of some transistors in the second pixel circuit, so that the driving group 11_B independently controls the display subarea B.

Based on this, the first driving group (driving group 11_A) includes M cascaded shift registers SRs. An input end of the first driving group is electrically connected to the first signal end (1) of the DDIC, to receive the start signal STV output by the first signal end (1) of the DDIC, where M ≥ 2, and M is a positive integer.

A first end of the first connection controller (connection controller 12_B) is electrically connected to an output end of the first driving group (driving group 11_A), to receive an active signal output by the first driving group (driving group 11_A).

A second end of the first connection controller (connection controller 12_B) is electrically connected to the second signal end (2) of the DDIC, to receive the cascade gating signal Sell output by the second signal end (2) of the DDIC.

A third end of the first connection controller (connection controller 12_B) is electrically connected to the third signal end (3) of the DDIC, to receive the split-screen gating signal Sel2 output by the third signal end (3) of the DDIC.

A fourth end of the first connection controller (connection controller 12_B) is electrically connected to the fourth signal end (4) of the DDIC, to receive the split-screen display signal STV_d output by the fourth signal end (4) of the DDIC.

The second driving group (driving group 11_B) includes N cascaded shift registers SRs. An input end of the second driving group (driving group 11_B) is electrically connected to a fifth end of the first connection controller (connection controller 12_B), to receive an active signal output by the fifth end of the first connection controller, where N ≥ 2, and N is a positive integer, and M and N may be the same or may be different. This disclosure sets no limitation thereto.

Using the structure shown in FIG. 7b as an example, in addition to including a first driving group (driving group 11_A), a first connection controller (connection controller 12_B), and a second driving group (driving group 11_B), the gate driving circuit 01 further includes a second connection controller such as a connection controller 12_C, and a third driving group such as a driving group 11_C.

In this case, the mobile terminal further includes a first pixel circuit, a second pixel circuit, and a third pixel circuit that are configured to display an image. The first pixel circuit is located in the display subarea A, the second pixel circuit is located in the display subarea B, and the third pixel circuit is located in the display subarea C.

In the first driving group (driving group 11_A) of the gate driving circuit 01, a signal output end of each level of shift register SR is electrically connected to gates of some transistors in the first pixel circuit, so that the driving group 11_A independently controls the display subarea A.

In the second driving group (driving group 11_B) of the gate driving circuit 02, a signal output end of each level of shift register SR is electrically connected to gates of some transistors in the second pixel circuit, so that the driving group 11_B independently controls the display subarea B.

In the third driving group (driving group 11_C) of the gate driving circuit 02, a signal output end of each level of shift register SR is electrically connected to gates of some transistors in the third pixel circuit, so that the driving group 11_C independently controls the display subarea C.

Based on this, a first end of the second connection controller (connection controller 12_C) is electrically connected to an output end of the second driving group (driving group 11_B), to receive an active signal output by the second driving group (driving group 11_B).

A second end of the second connection controller (connection controller 12_C) is electrically connected to the second signal end (2) of the DDIC, to receive the cascade gating signal Sell output by the second signal end (2) of the DDIC.

A third end of the second connection controller (connection controller 12_C) is electrically connected to the third signal end (3) of the DDIC, to receive the split-screen gating signal Sel2 output by the third signal end (3) of the DDIC.

A fourth end of the second connection controller (connection controller 12_C) is electrically connected to the fourth signal end (4) of the DDIC, to receive the split-screen display signal STV_d output by the fourth signal end (4) of the DDIC.

In addition, the third driving group (driving group 11_C) includes S cascaded shift registers SRs. An input end of the third driving group (driving group 11_C) is electrically connected to a fifth end of the second connection controller (connection controller 12_C), to receive an active signal output by the fifth end of the second connection controller (connection controller 12_C), where S ≥ 2, and S is a positive integer.

It should be noted that any one of the driving group 11_A, the driving group 11_B, and the driving group 11_C is the driving group 11. For ease of description, the driving groups 11 are differentiated by using letters such as "A", "B", and "C" according to positions at which the driving groups 11 are disposed.

In the embodiments of this disclosure, for ease of description, two adjacent driving groups 11 are referred to as an upper-level driving group and a lower-level driving group.

It should be noted that in the embodiments of this application, the upper-level driving group is a driving group 11 that includes the first-level shift register SR1 configured to receive the start signal STV. Alternatively, the upper-level driving group is a driving group 11 of two adjacent driving groups 11 that is closer to the first-level shift register SR1.

The lower-level driving group is a driving group 11 of two adjacent driving groups 11 that is farther away from the first-level shift register SR1.

For example, in FIG. 7b, of the driving group 11_A and the driving group 11_B, the driving group 11_A includes the first-level shift register SR1 configured to receive the start signal STV. Therefore, the driving group 11_A is an upper-level driving group, and the driving group 11_B is a lower-level driving group.

Alternatively, of the driving group 11_B and the driving group 11_C, the driving group 11_B is a driving group closer to the first-level shift register SR1. Therefore, the driving group 11_B is an upper-level driving group, and the driving group 11_C is a lower-level driving group.

In addition, as shown in FIG. 7b, there is at least one connection controller 12 between an upper-level driving group and a lower-level driving group, for example, the connection controller 12_B between the driving group 11_A and the driving group 11_B, and the connection controller 12_C between the driving group 11_B and the driving group 11_C.

It should be noted that either of the connection controller 12_B and the connection controller 12_C is the connection controller 12. For ease of description, the connection controllers 12 are differentiated by using letters such as "B" and "C" according to positions at which the connection controllers 12 are disposed.

Based on this, when the cascade gating signal Sell provided by the second signal end (2) of the DDIC is an active signal (for example, the Sell is at a high voltage), and the split-screen gating signal Sel2 provided by the third signal end (3) of the DDIC is an inactive signal (for example, Sel2 is at a low voltage), the connection controller 12 electrically connects the upper-level driving group and the lower-level driving group under control of the cascade gating signal Sell and the split-screen gating signal Sel2, so that a signal of the upper-level driving group is transmitted to the lower-level driving group.

In this case, a signal output end Oput of one level of shift register SR in the upper-level driving group is connected to a signal input end Iput of one level of shift register SR in the lower-level driving group, to implement cascading. In this case, a display subarea controlled by the upper-level driving group and a display subarea controlled by the lower-level driving group jointly display one image.

In addition, when the cascade gating signal Sell provided by the second signal end (2) of the DDIC is an inactive signal (for example, the Sell is at a low voltage), the split-screen gating signal Sel2 provided by the third signal end (3) of the DDIC is an active signal (for example, Sel2 is at a high voltage), and the split-screen display signal STV_d provided by the fourth signal end (4) of the DDIC is an active signal (for example, STV_d is at a high voltage), the connection controller 12 disconnects a path connection between the upper-level driving group and the lower-level driving group under control of the cascade gating signal Sell and the split-screen gating signal Sel2. The connection controller 12 transmits the split-screen display signal STV_d to the lower-level driving group. In this case, the display subarea controlled by the upper-level driving group does not display an image and stays in a screen-off state, and the display subarea controlled by the lower-level driving group displays an image independently.

For example, the display panel 10 is a full high definition (Full High Definition, FHD) display panel. A resolution of the display panel 10 may be 1920 × 1080.

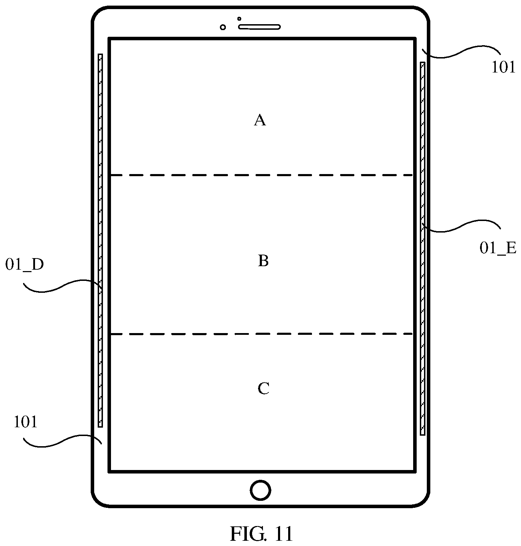

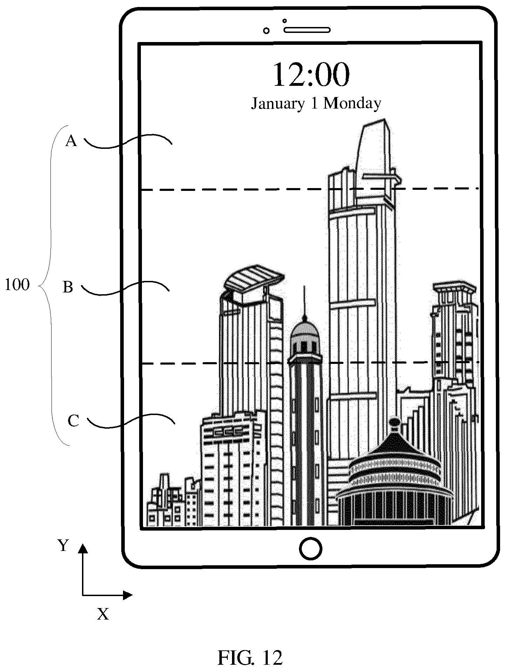

Based on this, when the display panel 10 uses a portrait mode shown in FIG. 11 or FIG. 12 for displaying, a displayed image is stretched in a vertical direction Y.

As shown in FIG. 7b, the active display area 100 of the display panel 10 has 1920 rows of sub pixels 20 in a horizontal direction X and has 1080 columns of sub pixels in a vertical direction Y.

In this case, the display subarea A includes sub pixels 20 in row 1 to row 640 in the horizontal direction X. The display subarea B includes sub pixels 20 in row 641 to row 1280 in the horizontal direction X. The display subarea C includes sub pixels 20 in row 1281 to row 1920 in the horizontal direction X.

The display subarea A, the display subarea B, and the display subarea C each have 1080 columns of sub pixels in the vertical direction Y.

The gate driving circuit 01 is located on a left side and/or a right side of the active display area 100. Descriptions are provided by using an example in which the gate driving circuit 01 is located on the left side of the active display area 100.

In this case, for example, the gate driving circuit 01 is configured to emit the light emitting control signal EM. In the pixel circuit 201 shown in FIG. 6A and FIG. 6B, the gates of the transistors M5 and M6 receive the light emitting control signal EM. The transistors M5 and M6 are light emitting control transistors.

Based on this, in the display subarea A, gates of light emitting transistors M5 and M6 in each pixel circuit 201 (namely, the first pixel circuit) of a same row of sub pixels 20 are connected to one level of shift register SR in the driving group 11_A.

In the display subarea B, gates of light emitting transistors M5 and M6 in each pixel circuit 201 (namely, the second pixel circuit) of a same row of sub pixels 20 are connected to one level of shift register SR in the driving group 11_B.

In the display subarea C, gates of transistors M5 and M6 in each pixel circuit 201 (namely, the third pixel circuit) of a same row of sub pixels 20 are connected to one level of shift register SR in the driving group 11_C.

The connection controller 12_B connects a signal output end Oput of one level of shift register SR in the driving group 11_A and a signal input end Iput of one level of shift register SR in the driving group 11_B.

The connection controller 12_C connects a signal output end Oput of one level of shift register SR in the driving group 11_B and a signal input end Iput of one level of shift register SR in the driving group 11_C.

When the driving group 11_A, the driving group 11_B, and the driving group 11_C form a path, the entire gate driving circuit 01 scans sub pixels 20 in the active display area 100 row by row in sequence from top to bottom, so that the display subarea A, the display subarea B, and the display subarea C jointly display a same image.

It should be noted that, descriptions are provided by using an example in which the mobile terminal shown in FIG. 7b is a mobile phone (which, for example, has a resolution of 1920 × 1080). In this case, a dimension of the mobile terminal in the horizontal direction X is less than a dimension of the mobile terminal in the vertical direction Y. In addition, because of a relatively large difference between the dimension of the mobile terminal in the horizontal direction X and the dimension of the mobile terminal in the vertical direction Y, an outline of the mobile terminal assumes a narrow long shape shown in FIG. 12.

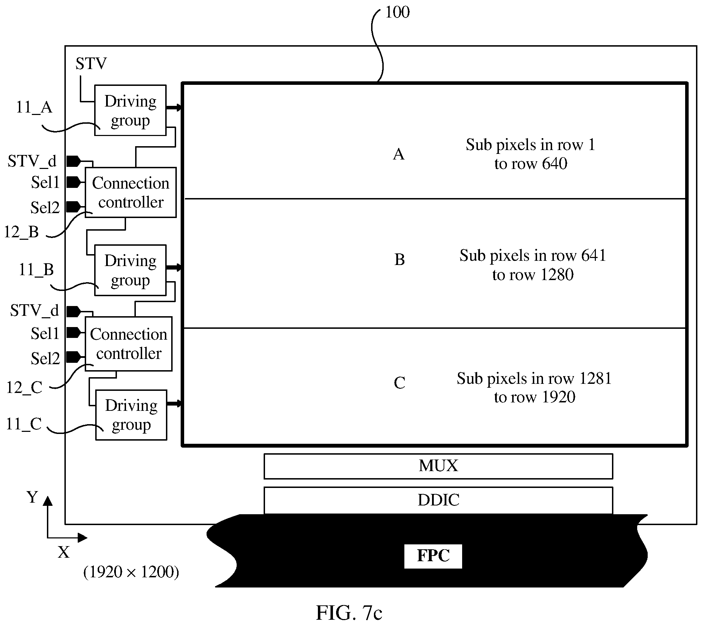

In some other embodiments of this application, the mobile terminal may be a tablet computer (with a resolution of 1920 × 1200), as shown in FIG. 7c.

Division of display subareas in the mobile terminal and setting manners of driving groups 11 in a gate driving circuit are similar to those in FIG. 7b. A dimension of the tablet computer in a horizontal direction X may also be less than a dimension of the tablet computer in a vertical direction Y. A difference lies in that compared to the mobile phone, the tablet computer has a smaller difference between the dimension in the horizontal direction X and the dimension in the vertical direction Y, and an outline of the mobile terminal is close to a square. For ease of description, all the following embodiments are described by using an example in which the mobile terminal is a mobile phone.

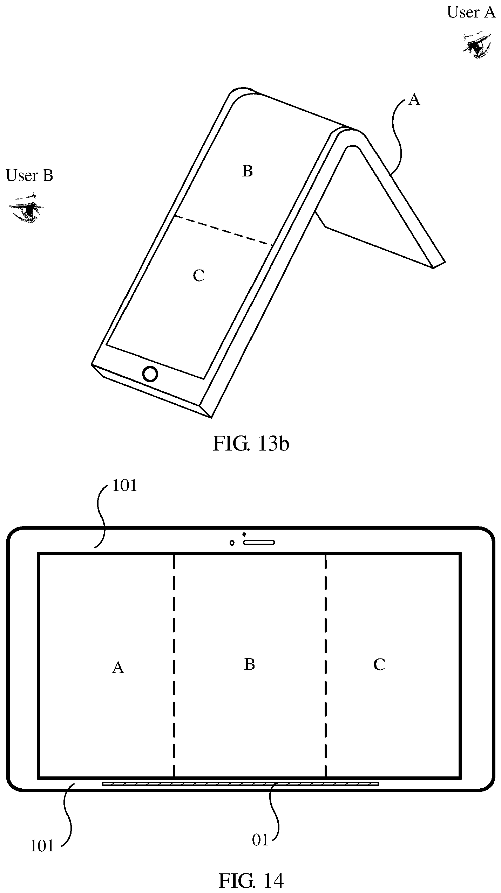

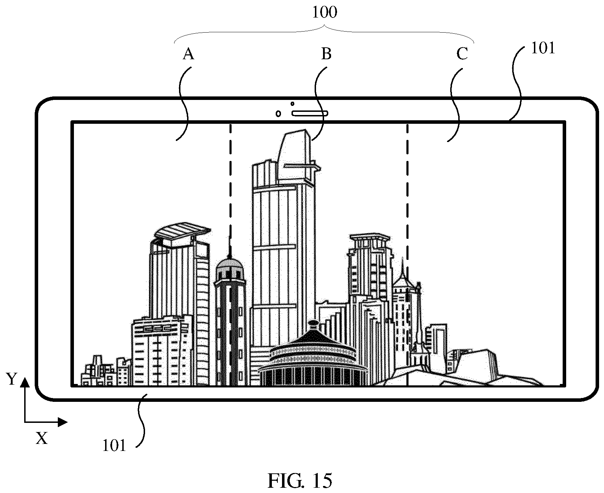

When a display panel 10 of a mobile terminal provided in still some other embodiments of this application uses a landscape mode shown in FIG. 14 or FIG. 15 for displaying, a displayed image is stretched in a horizontal direction X.

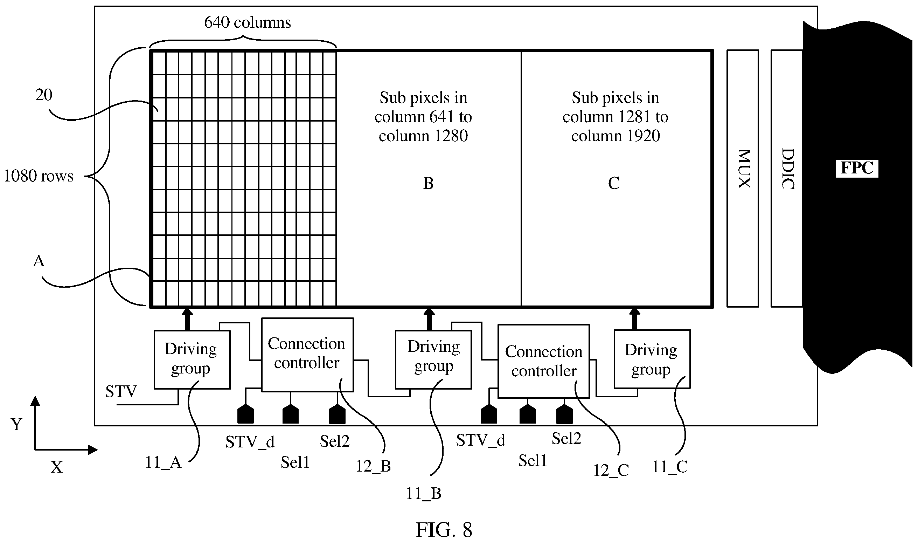

As shown in FIG. 8, an active display area 100 has 1080 rows of sub pixels 20 in a horizontal direction X and has 1920 columns of sub pixels in a vertical direction Y.

In this case, a display subarea A includes sub pixels 20 in column 1 to column 640 in the vertical direction Y. A display subarea B includes sub pixels 20 in column 641 to column 1280 in the vertical direction Y. A display subarea C includes sub pixels 20 in column 1281 to column 1920 in the vertical direction Y.

The display subarea A, the display subarea B, and the display subarea C each have 1080 rows of sub pixels in the horizontal direction X.

A gate driving circuit 01 is located on an upper side and/or a lower side of the active display area 100. Descriptions are provided in an example in which the gate driving circuit 01 is located on the lower side of the active display area 100.

In this case, for example, the gate driving circuit 01 is configured to emit the light emitting control signal EM. In the pixel circuit 201 shown in FIG. 6A and FIG. 6B, the gates of the transistors M5 and M6 receive the light emitting control signal EM.

Based on this, in the display subarea A, gates of transistors M5 and M6 in a pixel circuit 201 of a column of sub pixels 20 are connected to one level of shift register SR in the driving group 11_A.

In the display subarea B, gates of transistors M5 and M6 in a pixel circuit 201 of a column of sub pixels 20 are connected to one level of shift register SR in the driving group 11_B.

In the display subarea C, gates of transistors M5 and M6 in a pixel circuit 201 of a column of sub pixels 20 are connected to one level of shift register SR in the driving group 11_C.

A connection controller 12_B connects a signal output end Oput of one level of shift register SR in a driving group 11_A and a signal input end Iput of one level of shift register SR in a driving group 11_B.

A connection controller 12_C connects a signal output end Oput of one level of shift register SR in the driving group 11_B and a signal input end Iput of one level of shift register SR in a driving group 11_C.

When the driving group 11_A, the driving group 11_B, and the driving group 11_C form a path, the entire gate driving circuit 01 scans sub pixels 20 in the active display area 100 column by column in sequence from left to right, so that the display subarea A, the display subarea B, and the display subarea C jointly display a same image.

In any display manner shown in FIG. 7b or FIG. 8, the connection controller 12 may connect or disconnect a connection path between an upper-level driving group and a lower-level driving group that are connected to the connection controller 12.

For example, when the connection controller 12_B disconnects a connection path between the driving group 11_A and the driving group 11_B, the connection controller 12_B may transmit an STV_d_B signal to the driving group 11_B, to control the display subarea B to perform displaying independently.

When the connection controller 12_C disconnects a connection path between the driving group 11_B and the driving group 11_C, the connection controller 12_C may transmit an STV_d_C signal to the driving group 11_C, to control the display subarea C to perform displaying independently.

In addition, when the connection controller 12_B disconnects the connection path between the driving group 11_A and the driving group 11_B and the connection controller 12_C disconnects the connection path between the driving group 11_B and the driving group 11_C, a start signal STV provides a high voltage for the driving group 11_A, to enable the driving group 11_A to control the display subarea A to perform displaying independently.

It should be noted that either of the split-screen gating signal STV_d_B and the split-screen gating signal STV_d_C is the foregoing split-screen gating signal STV_d. For ease of description, the split-screen gating signals STV_d are differentiated by using letters such as "B" and "C" based on different locations at which the split-screen gating signals STV_d are received in the gate driving circuit 01.

In addition, in the example for description of FIG. 7b or FIG. 8, the gate driving circuit 01 is located on one side of the active display area 10. To facilitate narrow-bezel design of the display panel 10 of the mobile terminal, as shown in FIG. 11, a first gate driving circuit 01_D and a second gate driving circuit 01_E may be respectively disposed on the left and right (or upper and lower) sides of the active display area 100.

In the first gate driving circuit 01_D, a signal output end of each level of shift register SR in each first driving group (driving group 11_A) is electrically connected to gates of some transistors in a first pixel circuit in an odd-numbered row or column. A signal output end of each level of shift register SR in each second driving group (driving group 11_B) is electrically connected to gates of some transistors in a second pixel circuit in an odd-numbered row or column. In this case, a first gate driving circuit 01_A is configured to control a sub pixel 20 in the odd-numbered row (or column).

In addition, in the second gate driving circuit 01_E, a signal output end of each level of shift register SR in each first driving group (driving group 11_A) is electrically connected to gates of some transistors in a first pixel circuit in an even-numbered row or column. A signal output end of each level of shift register SR in each second driving group (driving group 11_B) is electrically connected to gates of some transistors in a second pixel circuit in an even-numbered row or column. In this case, a second gate driving circuit 01_B is configured to control a sub pixel 20 in the even-numbered row (or column).

The first gate driving circuit 01_D and the second gate driving circuit 01_E are two independent circuits, and setting manners of a driving group 11 and a connection controller 12 in any sub circuit are the same as those described above. Details are not described herein again.

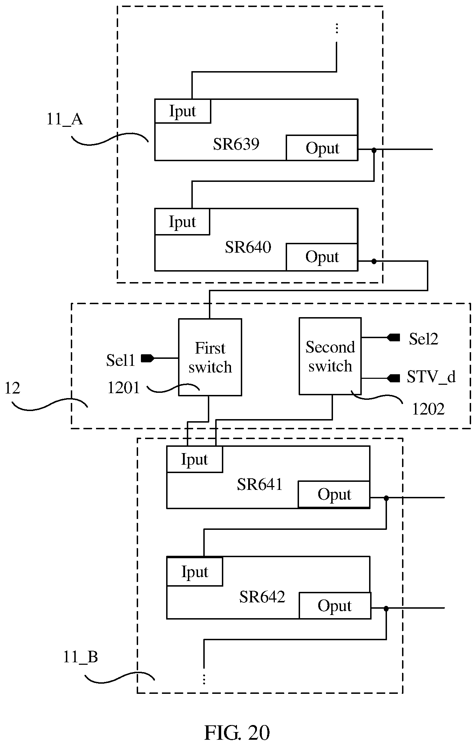

Based on this, any connection controller 12 of the first connection controller (connection controller 12_B) or the second connection controller (connection controller 12_C) includes a first switch 1201 and a second switch 1202 shown in FIG. 20.

The following describes a structure for connecting the first switch 1201 and the second switch 1202 in the first connection controller (connection controller 12_B).

The first switch 1201 is electrically connected to the second signal end (2) of the DDIC, the output end of the first driving group (driving group 11_A), and the input end of the second driving group (driving group 11_B).

The first switch 1201 is configured to receive the cascade gating signal Sell output by the second signal end (2) of the DDIC and is enabled or disabled under control of the cascade gating signal Sell, and in the enabled state, transmits, to the input end of the second driving group (driving group 11_B), the received active signal output by the output end of the first driving group (driving group 11_A).

The second switch 1202 is electrically connected to the third signal end (3) of the DDIC, the fourth signal end (4) of the DDIC, and the input end of the second driving group (driving group 11_B).

The second switch 1202 is configured to receive the split-screen gating signal Sel2 output by the third signal end (3) of the DDIC and is enabled or disabled under control of the split-screen gating signal Sel2, and in the enabled state, transmits, to the input end of the second driving group (driving group 11_B), the received split-screen display signal SIV_d that is output by the fourth signal end (4) of the DDIC.

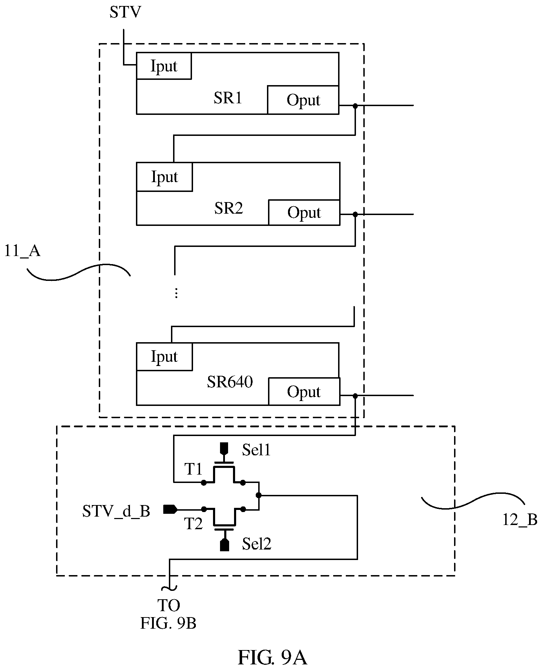

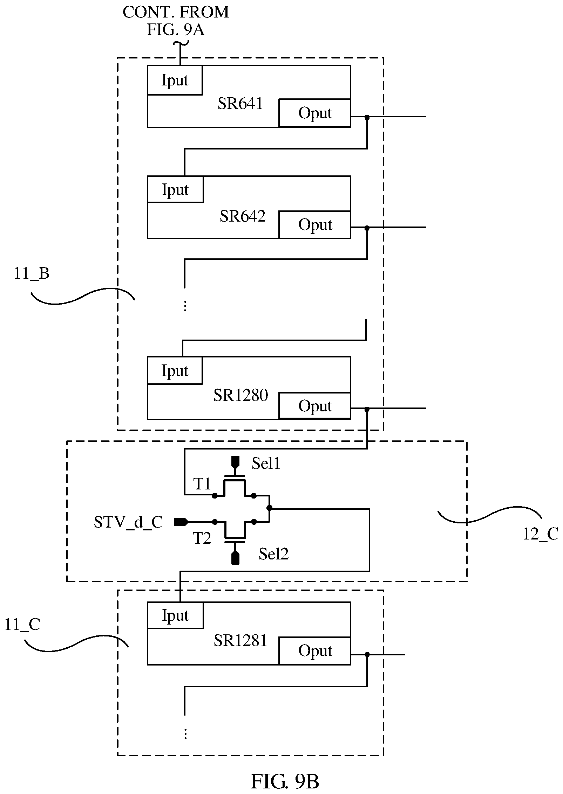

Based on this, the first switch 1201 includes a first transistor T1 shown in FIG. 9A and FIG. 9B. The second switch 1202 includes a second transistor T2 shown in FIG. 9A and FIG. 9B. The following describes a structure for connecting the first transistor T1 and the second transistor T2 in the first connection controller (connection controller 12_B).

A gate of the first transistor T1 is connected to the second signal end (2) of the DDIC. A first electrode of the first transistor T1 is connected to an output end of a first driving group, for example, a signal output end Oput of a last-level shift register SR in the driving group 11_A. A second electrode of the first transistor T1 is connected to an input end of a second driving group, for example, a signal input end Iput of a first-level shift register SR in the driving group 11_B.

A gate of the second transistor T2 is connected to the third signal end (3) of the DDIC. A first electrode of the second transistor T2 is connected to the fourth signal end (4) of the DDIC. A second electrode of the second transistor T2 is connected to an input end of a second driving group, for example, the signal input end of the first-level shift register SR in the driving group 11_B.

When the first connection controller (connection controller 12_B) includes the first transistor T1 and the second transistor T2, the first end of the first connection controller is the first electrode of the first transistor T1. The second end of the first connection controller is the gate of the first transistor T1. The third end of the first connection controller is the gate of the second transistor T2. The fourth end of the first connection controller is the first electrode of the second transistor T2. The fifth end of the first connection controller is the second electrode of the second transistor T2.

In addition, the second connection controller (connection controller 12_C) also includes a first transistor T1 and a second transistor T2. Therefore, the five signal ends of the second connection controller are the same as those described above. Details are not described herein again.

It should be noted that the first transistor T1 and the second transistor T2 may be thin film transistors (thin film transistor, TFT) or metal-oxide semiconductor (metal-oxide-semiconductor, MOS) field- effect transistors. In addition, the first transistor T1 and the second transistor T2 may be N-type transistors or P-type transistors. The first electrodes of the first transistor T1 and the second transistor T2 may be sources, and the second electrodes of the first transistor T1 and the second transistor T2 may be drains. Alternatively, the first electrodes of the first transistor T1 and the second transistor T2 are drains, and the second electrodes of the first transistor T1 and the second transistor T2 are sources. The embodiments of this application set no limitation thereto. For ease of description, in the following embodiments, an example in which the first transistor T1 and the second transistor T2 are N-type transistors is used. The following illustrates manners of connecting the first transistor T1 and the second transistor T2 to shift registers SRs in a first driving group and a second driving group.

For example, as shown in FIG. 9A and FIG. 9B, for any driving group 11, in a plurality of shift registers other than a first-level shift register in the driving group 11, a signal output end Oput of an upper-level shift register is connected to a signal input end Iput of a lower-level shift register.

In this case, as shown in FIG. 9A and FIG. 9B, in the connection controller 12, the first electrode of the first transistor T1 is connected to a signal output end Oput of a last-level shift register SR640 in a first driving group, for example, the driving group 11_A. The second electrode of the first transistor T1 is connected to a signal input end Iput of a first-level shift register SR641 in a second driving group, for example, the driving group 11_B.

The second electrode of the second transistor T2 is connected to the signal input end Iput of the first-level shift register SR641 in the second driving group, for example, the driving group 11_B.

It should be noted that, as shown in FIG. 1, the first-level shift register in the driving group 11-A is the first-level shift register SR1 configured to receive the start signal STV in the entire gate driving circuit 01. The first-level shift register in the driving group 11_B is the shift register SR641. The first-level shift register in the driving group 11_C is a shift register SR1281.

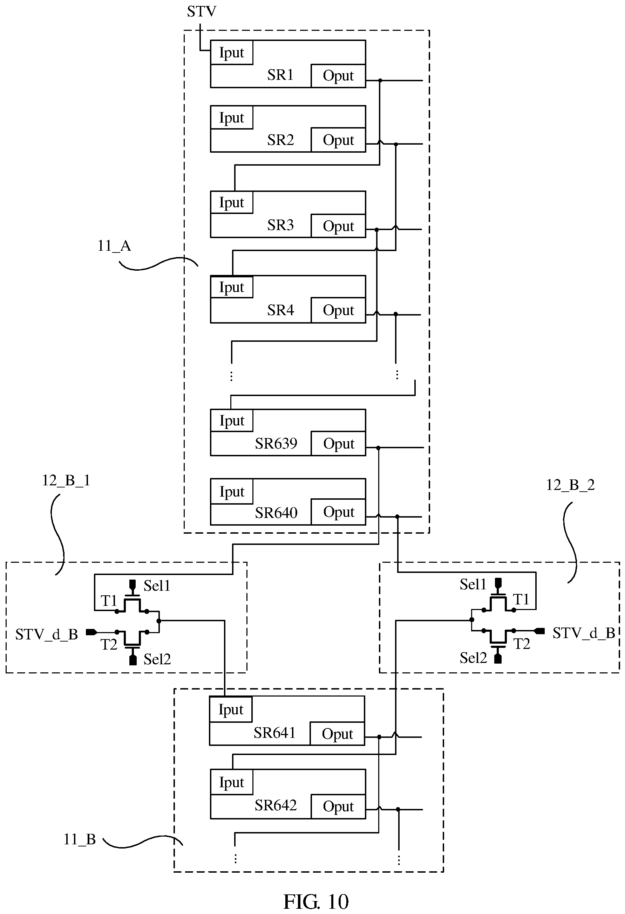

Alternatively, for example, when two shift registers SRs in the driving group 11 that are not adjacent to each other are cascaded, as shown in FIG. 10, in each driving group 11, a plurality of shift registers SRs in sub pixels 20 in odd-numbered rows (or columns) are cascaded under control, and a plurality of shift registers SRs in even-numbered rows (or columns) are cascaded under control.

Using a driving group 11_A as an example, a signal output end Oput of a shift register SR1 is connected to a signal input end Iput of a shift register SR3. A signal output end Oput of the shift register SR3 is connected to a signal input end Iput of a shift register SR5.

In addition, a signal output end Oput of a shift register SR2 is connected to a signal input end Iput of a shift register SR4. A signal output end Oput of the shift register SR4 is connected to a signal input end Iput of a shift register SR6.

In this case, two connection controllers 12, which are respectively a connection controller 12_B1 and a connection controller 12B_2 shown in FIG. 10, may be disposed between the driving group 11_A and a driving group 11_B.

In this case, as shown in FIG. 10, in the connection controller 12_B1, a first electrode of a first transistor T1 is connected to a signal output end Oput of a last-level shift register SR639 that is configured to control a sub pixel 20 in an odd-numbered row (or column) and that is in a first driving group, for example, the driving group 11_A. A second electrode of the first transistor T1 is connected to a signal input end Iput of a first-level SR641 that is configured to control a sub pixel 20 in an odd-numbered row (or column) and that is in a second driving group, for example, the driving group 11_B.

A second electrode of a second transistor T2 is connected to the signal input end of the first-level shift register SR641 that is configured to control a sub pixel 20 in an odd-numbered row (or column) and that is in the second driving group, for example, the driving group 11_B.

In addition, in the connection controller 12_B2, a first electrode of a first transistor T1 is connected to a signal output end Oput of a last-level shift register SR640 that is configured to control a sub pixel 20 in an even-numbered row (or column) and that is in the first driving group, for example, the driving group 11_A. A second electrode of the first transistor T1 is connected to a signal input end Iput of a first-level shift register SR642 that is configured to control a sub pixel 20 in an even-numbered row (or column) and that is in the second driving group, for example, the driving group 11_B.

A second electrode of a second transistor T2 is connected to the signal input end of the first-level shift register SR642 that is configured to control a sub pixel 20 in an even-numbered row (or column) and that is in the second driving group, for example, the driving group 11_B.

In addition, a manner of disposing two connection controllers 12_C between the driving group 11_B and a driving group 11_C is the same as the manner described above. Details are not described herein again.

It should be noted that the foregoing only illustrates a manner of cascading a plurality of shift registers in a same driving group 11. However, cascading manners of this disclosure are not limited to the foregoing two examples. For example, a signal output end Oput of an i^{th}-level shift register SRm may be connected to a signal input end Iput of an (i+j)^{th}-level shift register SR(i+j), where i ≥ 1, j ≥ 1, and i and j are positive integers.

In this case, a quantity of connection controllers 12 between two adjacent driving groups 11 may be set as required, to ensure that display subareas in the active display area 100 jointly display a same image.

The gate driving circuit 01 provided in the embodiments of this application may be applied to the liquid crystal display panel. The liquid crystal display panel cannot emit light by itself. Therefore, a backlight module configured to provide a light source for the liquid crystal display panel needs to be disposed on a back side (a surface disposed opposite to a light emitting surface) of the liquid crystal display panel. In addition, the backlight module is a direct type backlight module.

In this case, when the active display area 100 of the liquid crystal display panel includes the display subarea A, the display subarea B, and the display subarea C, the backlight module may also be divided into three backlight zones whose light emitting or disablement can be controlled independently. The three backlight zones respectively correspond to the display subarea A, the display subarea B, and the display subarea C. In this way, independent display in each display subarea can be implemented by using the connection controller 12, and a backlight zone corresponding to a display subarea that does not perform displaying does not emit light.

Alternatively, the gate driving circuit 01 may be applied to the OLED display panel. In this case, independent display in the display subarea A, the display subarea B, and the display subarea C in the active display area 100 of the OLED display panel may also be implemented by using the connection controller 12.

In addition, the underlying substrate for carrying the pixel circuit 201 in the OLED display panel may be made of a flexible resin material, and a packaging substrate of the OLED display panel may use a tape carrier package. In this case, the OLED display panel is a flexible display substrate. A user may fold the OLED display panel as needed, and after the folding, select some display subareas to perform displaying independently.

It can be learned from the foregoing descriptions that at stage (3) shown in FIG. 4, the driving current Isd generated by the driving transistor M4 is transmitted to the OLED under control of the light emitting control signal EM, to drive the OLED to emit light, so that the sub pixels 20 having the pixel circuits 201 perform displaying. Therefore, the light emitting control signal EM is mainly used to control the sub pixels 20 to perform displaying. Therefore, to enable each display subarea in the OLED display panel to perform displaying independently, a structure of the gate driving circuit 01 that provides the light emitting control signal EM for each row of sub pixels 20 needs to be the structure, shown in FIG. 9A and FIG. 9B or FIG. 10, in which the connection controller 12 is disposed.

The following illustrates in detail various display scenarios, for example, full screen or bending of the OLED display panel or independent display in each display subarea, by using an example in which the OLED display panel is a flexible display panel and the gate driving circuit 01 shown in FIG. 9A and FIG. 9B is configured to provide the light emitting control signal EM for each row of sub pixels 20.

As shown in FIG. 11, the active display area 100 of the OLED display panel is divided into a display subarea A, a display subarea B, and a display subarea C in sequence from top to bottom. In this case, the gate driving circuit 01 configured to provide the light emitting control signal EM is disposed in a non-display area 101 on a left side and/or a right side of the active display area 100.

### Example 1

In this example, the display subarea A, the display subarea B, and the display subarea C in the active display area 100 of the OLED display panel all perform displaying, and the display subarea A, the display subarea B, and the display subarea C jointly display a same image.

Based on this, Table 1 shows an on/off control status of transistors in connection controllers 12 in the gate driving circuit 01 shown in FIG. 9A and FIG. 9B and signals input by some signal ends.

**Table 1**

| Display subareas | T1 (12_B) | T2 (12_B) | T1 (12_C) | T2 (12_C) | STV | STV_d_B | STV_d_C |
|---|---|---|---|---|---|---|---|
| A+B+C | ON | OFF | ON | OFF | H | L | L |

It should be noted that in the embodiments of this application, H represents a high voltage, namely, an active start signal output by a signal end; and L represents a low voltage, namely, an inactive non-start signal output by a signal end.

To enable the display subarea A, the display subarea B, and the display subarea C to jointly display a same image, refer to Table 1. In the following embodiments, a driving circuit that controls the display subarea A is the driving group 11_A, a driving circuit that controls the display subarea B is the driving group 11_B, and a driving circuit that controls the display subarea C is the driving group 11_C.

The second signal end (2) of the DDIC inputs a high-voltage cascade gating signal Sel to the gate of the first transistor T1 in the connection controller 12_B, to turn on (ON) the first transistor T1 in the connection controller 12_B. In this case, the signal output end Oput of the last-level shift register SR, for example, the RS640, in the driving group 11_A is connected to the signal input end Iput of the first-level shift register SR, for example, the RS641, in the driving group 11_B.

In addition, the third signal end (3) of the DDIC inputs a low-voltage split-screen gating signal Sel2 to the gate of the second transistor T2 in the connection controller 12_B, to turn off (OFF) the second transistor T2 in the connection controller 12_B. In addition, the fourth signal end (4) of the DDIC inputs a low-voltage split-screen display signal STV_d_B to the first electrode of the second transistor T2, and the low-voltage split-screen display signal STV_d_B is used as an inactive non-start signal, to prevent the fourth signal end (4) of the DDIC from staying in a floating (floating) state. In this case, the display subarea B cannot perform displaying independently.

In addition, the second signal end (2) of the DDIC inputs a high-voltage cascade gating signal Sell to a gate of the first transistor T1 in the connection controller 12_C, to turn on (ON) the first transistor T1 in the connection controller 12_C.

In this case, a signal output end Oput of a last-level shift register SR, for example, an RS1280, in the driving group 11_B is connected to a signal input end Iput of a first-level shift register SR, for example, an RS1281, in the driving group 11_C. In addition, the third signal end (3) of the DDIC inputs a low-voltage split-screen gating signal Sel2 to a gate of the second transistor T2 in the connection controller 12_C, to turn off (OFF) the second transistor T2 in the connection controller 12_C. The fourth signal end (4) of the DDIC inputs a low-voltage split-screen display signal STV_d_C to a first electrode of the second transistor T2, and the low-voltage split-screen display signal STV_d_C is used as an inactive non-start signal, to prevent the fourth signal end (4) of the DDIC from staying in a floating (floating) state. In this case, the display subarea C cannot perform displaying independently.

In this case, the driving group 11_A is cascaded to the driving group 11_B, and the driving group 11_B is cascaded to the driving group 11_C. The driving group 11_A, the driving group 11_B, and the driving group 11_C form a path.

In this case, when a start signal STV is at a high voltage, the high voltage is provided as a start signal to a signal input end Iput of the first-level shift register SR1 in the driving group 11_A. Based on this, in an image frame, signal output ends Oput of all levels of shift registers SRs in the driving group 11_A input a light emitting control signal EM to the sub pixels 20 in the display subarea A row by row. Next, an active signal output by the signal output end Oput of the last-level shift register SR, for example, the SR640, in the driving group 11_A is used as a start signal and is transmitted to the signal input end Iput of the first-level shift register SR, for example, the SR641, in the driving group 11_B. Next, signal output ends Oput of all levels of shift registers SRs in the driving group 11_B input a light emitting control signal EM to the sub pixels 20 in the display subarea B row by row. Next, an active signal output by the signal output end Oput of the last-level shift register SR, for example, the SR1280, in the driving group 11_B is used as a start signal and is transmitted to the signal input end Iput of the first-level shift register SR, for example, the SR1281, in the driving group 11_C. Finally, signal output ends Oput of all levels of shift registers SRs in the driving group 11_C input a light emitting control signal EM to the sub pixels 20 in the display subarea C row by row. In an image frame, as shown in FIG. 12, the sub pixels 20 in the display subarea A, the display subarea B, and the display subarea C are scanned row by row in sequence, so that the display subarea A, the display subarea B, and the display subarea C jointly display a same image after scanning the image frame is completed.

### Example 2

In this example, the display subarea A, the display subarea B, and the display subarea C in the active display area 100 of the OLED display panel all perform displaying. The display subarea A displays a first image independently, and the display subarea B and the display subarea C jointly display a second image.

Based on this, Table 2 shows an on/off control status of transistors in connection controllers 12 in the gate driving circuit 01 in FIG. 9A and FIG. 9B and signals input by some signal ends.

**Table 2**

| Display subareas | T1 (12_B) | T2 (12_B) | T1 (12_C) | T2 (12_C) | STV | STV_d_B | STV_d_C |
|---|---|---|---|---|---|---|---|
| A and B+C | OFF | ON | ON | OFF | H | H | L |

To enable the display subarea A to perform displaying independently, refer to Table 2. The second signal end (2) of the DDIC inputs a low-voltage cascade gating signal Sell to the gate of the first transistor T1 in the connection controller 12_B shown in FIG. 9A and FIG. 9B, to turn off (OFF) the first transistor T1 in the connection controller 12_B. In this case, a path between the driving group 11_A and the driving group 11_B is disconnected.

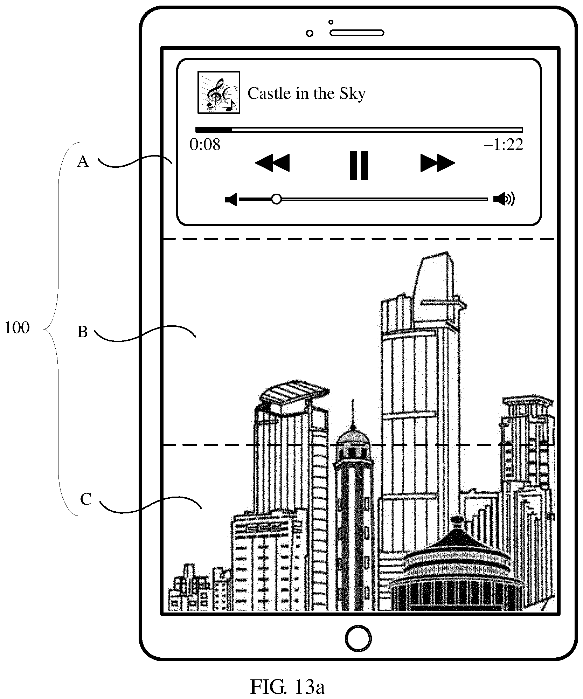

In this case, when a start signal STV is at a high voltage, the high voltage is provided as a start signal to a signal input end Iput of the first-level shift register SR1 in the driving group 11_A. In an image frame, signal output ends Oput of all levels of shift registers SRs in the driving group 11_A input a light emitting control signal EM to the sub pixels 20 in the display subarea A row by row. Because the first transistor T1 in the connection controller 12_B is turned off (OFF), an active signal output by the signal output end Oput of the last-level shift register SR, for example, the SR640, in the driving group 11_A cannot be transmitted to the signal input end Iput of the first-level shift register SR, for example, the SR641, in the driving group 11_B. In this way, as shown in FIG. 13a, the display subarea A may display the first image independently, for example, display a player. In addition, to enable the display subarea B and the display subarea C to jointly display the second image, the second signal end (2) of the DDIC inputs a high-voltage cascade gating signal Sell to a gate of the first transistor T1 in the connection controller 12_C, to turn on (ON) the first transistor T1 in the connection controller 12_C. The third signal end (3) of the DDIC inputs a low-voltage split-screen gating signal Sel2 to a gate of the second transistor T2 in the connection controller 12_C, to turn off (OFF) the second transistor T2 in the connection controller 12_C. The fourth signal end (4) of the DDIC inputs a low-voltage split-screen display signal STV_d_C, and the low-voltage split-screen display signal STV_d_C is used as an inactive non-start signal, to prevent the fourth signal end (4) of the DDIC from staying in a floating (floating) state.

In this case, the driving group 11_B is cascaded to the driving group 11_C. A path is formed between the driving group 11_B and the driving group 11_C.

In this case, the third signal end (3) of the DDIC inputs a high-voltage split-screen gating signal Sel2 to the gate of the second transistor T2 in the connection controller 12_B, to turn on (ON) the second transistor T2 in the connection controller 12_B. The fourth signal end (4) of the DDIC inputs a high-voltage split-screen display signal STV_d_B, and the high-voltage split-screen display signal STV_d_B is provided as a start signal to the signal input end Iput of the first-level shift register SR641 in the driving group 11_B. Based on this, in an image frame, signal output ends Oput of all levels of shift registers SRs in the driving group 11_B input a light emitting control signal EM to the sub pixels 20 in the display subarea B row by row. Next, an active signal output by a signal output end Oput of a last-level shift register SR, for example, an SR1280, in the driving group 11_B is used as a start signal and is transmitted to a signal input end Iput of a first-level shift register SR, for example, an SR1281, in the driving group 11_C. Then, signal output ends Oput of all levels of shift registers SRs in the driving group 11_C input a light emitting control signal EM to the sub pixels 20 in the display subarea C row by row. In an image frame, as shown in FIG. 13a, the sub pixels 20 in the display subarea B and the display subarea C are scanned row by row in sequence, so that the display subarea B and the display subarea C joint display the second image after the image frame ends.

Based on this, when there are at least two users, for example, a user A and a user B using the same mobile terminal, as shown in FIG. 13b, the mobile terminal may be bent, so that the display subarea A that can display independently faces the user A, and the display subarea B and the display subarea C face the user B. In addition, when the display subarea A is flipped over to a direction back-to-back with the display subareas B and C, the mobile terminal may flip a picture in the display subarea A according to gravity sensing, so that the user A does not see an upside-down picture.

In another embodiment, the display subarea C may display a first image, and the display subarea A and the display subarea B jointly display a second image. Table 3 shows an on/off control status of transistors in connection controllers 12 and signals input by some signal ends.

**Table 3**

| Display subareas | T1 (12_B) | T2 (12_B) | T1 (12_C) | T2 (12_C) | STV | STV_d_B | STV_d_C |
|---|---|---|---|---|---|---|---|
| A+B and C | ON | OFF | OFF | ON | H | L | H |

The second signal end (2) of the DDIC inputs a high-voltage cascade gating signal Sell to the gate of the first transistor T1 in the connection controller 12_B, to turn on (ON) the first transistor T1 in the connection controller 12_B. A path between the driving group 11_A and the driving group 11_B is connected. The third signal end (3) of the DDIC inputs a low-voltage split-screen gating signal Sel2 to the gate of the second transistor T2 in the connection controller 12_B, to turn off (OFF) the second transistor T2 in the connection controller 12_B. The fourth signal end (4) of the DDIC inputs a low-voltage STV_d_B, and the low-voltage STV_d_B is used as an inactive non-start signal.

When a start signal STV is at a high voltage, the high voltage is provided as a start signal to a signal input end Iput of the first-level shift register SR1 in the driving group 11_A. Based on this, in an image frame, signal output ends Oput of all levels of shift registers SRs in the driving group 11_A input a light emitting control signal EM to the sub pixels 20 in the display subarea A row by row. Next, an active signal output by the signal output end Oput of the last-level shift register SR in the driving group 11_A is used as a start signal and is transmitted to the signal input end Iput of the first-level shift register SR in the driving group 11_B. Next, signal output ends Oput of all levels of shift registers SRs in the driving group 11_B input a light emitting control signal EM to the sub pixels 20 in the display subarea B row by row. In the image frame, the sub pixels 20 in the display subarea A and the display subarea B are scanned row by row in sequence, so that the display subarea A and the display subarea B jointly display the second image.

In addition, the second signal end (2) of the DDIC inputs a low-voltage cascade gating signal Sell to a gate of the first transistor T1 in the connection controller 12_C, to turn off (OFF) the first transistor T1 in the connection controller 12_C. A path between the driving group 11_B and the driving group 11_C is disconnected. An active signal output by a signal output end Oput of a last-level shift register SR, for example, an SR1280, in the driving group 1 1_B cannot be transmitted to a signal input end Iput of a first-level shift register SR, for example, an SR1281, in the driving group 11_C.

The third signal end (3) of the DDIC inputs a high-voltage split-screen gating signal Sel2 to a gate of the second transistor T2 in the connection controller 12_C, to turn on (ON) the second transistor T2 in the connection controller 12_B. The fourth signal end (4) of the DDIC inputs a high-voltage split-screen display signal STV_d_C. It can be learned by analogy that the display subarea C displays the first image.

In another embodiment, the display subarea A, the display subarea B, and the display subarea C respectively display a first image, a second image, and a third image. Table 4 shows an on/off control status of transistors in connection controllers 12 and signals input by some signal ends.

**Table 4**

| Display subareas | T1 (12_B) | T2 (12_B) | T1 (12_C) | T2 (12_C) | STV | STV_d_B | STV_d_C |
|---|---|---|---|---|---|---|---|
| A, B, and C | OFF | ON | OFF | ON | H | H | H |

The second signal end (2) of the DDIC inputs a low-voltage cascade gating signal Sell to the gate of the first transistor T1 in the connection controller 12_B, to turn off (OFF) the first transistor T1 in the connection controller 12_B. A path between the driving group 11_A and the driving group 11_B is disconnected. An active signal output by the signal output end Oput of the last-level shift register SR, for example, the SR640, in the driving group 11_A cannot be transmitted to the signal input end Iput of the first-level shift register SR, for example, the SR641, in the driving group 11_B. When a start signal STV is at a high voltage, it can be learned by analogy that the display subarea A displays the first image.

The third signal end (3) of the DDIC inputs a high-voltage split-screen gating signal Sel2 to the gate of the second transistor T2 in the connection controller 12_B, to turn on (ON) the second transistor T2 in the connection controller 12_B. The fourth signal end (4) of the DDIC inputs a high-voltage split-screen display signal STV_d_B. It can be learned by analogy that the display subarea B displays the second image.

In addition, the second signal end (2) of the DDIC inputs a low-voltage cascade gating signal Sell to a gate of the first transistor T1 in the connection controller 12_C, to turn off (OFF) the first transistor T1 in the connection controller 12_C. A path between the driving group 11_B and the driving group 11_C is disconnected. An active signal output by a signal output end Oput of a last-level shift register SR, for example, an SR1280, in the driving group 1 1_B cannot be transmitted to a signal input end Iput of a first-level shift register SR, for example, an SR1281, in the driving group 11_C.

The third signal end (3) of the DDIC inputs a high-voltage split-screen gating signal Sel2 to a gate of the second transistor T2 in the connection controller 12_C, to turn on (ON) the second transistor T2 in the connection controller 12_C. The fourth signal end (4) of the DDIC inputs a high-voltage split-screen display signal STV_d_C. It can be learned by analogy that the display subarea C displays the third image.

The foregoing descriptions are provided by using an example in which the display subarea A, the display subarea B, and the display subarea C in the active display area 100 all perform displaying. The following descriptions are provided by using an example in which at least one display subarea of a display subarea A, a display subarea B, and a display subarea C does not display an image when an OLED display panel is folded. Because only some display subareas in an active display area 100 perform displaying, power saving is achieved.

For example, the OLED display panel performs displaying in a landscape mode. As shown in FIG. 14, an active display area 100 of an OLED display panel is divided into a display subarea A, a display subarea B, and a display subarea C in sequence from left to right. In this case, the gate driving circuit 01 configured to provide the light emitting control signal is disposed in a non-display area 101 on a lower side and/or a lower side of the active display area 100. In addition, FIG. 15 is a schematic diagram in which a display subarea A, a display subarea B, and a display subarea C all perform displaying before an OLED display panel is folded.

### Example 3

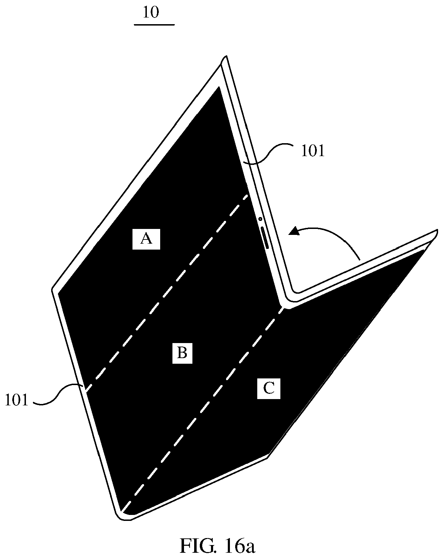

In this example, the display subarea A and the display subarea B in the active display area 100 of the OLED display panel jointly display a same image. As shown in FIG. 16a, the display subarea C is bent to a back side (namely, a non-display side) of the OLED display panel.

Based on this, Table 5 shows an on/off control status of transistors in connection controllers 12 in the gate driving circuit 01 in FIG. 9A and FIG. 9B and signals input by some signal ends.

**Table 5**

| Display subareas | T1 (12_B) | T2 (12_B) | T1 (12_C) | T2 (12_C) | STV | STV_d_B | STV_d_C |
|---|---|---|---|---|---|---|---|
| A+B | ON | OFF | OFF | ON | H | L | L |

To enable the display subarea A and the display subarea B to jointly display a same image, refer to Table 5. The second signal end (2) of the DDIC inputs a high-voltage cascade gating signal Sell to the gate of the first transistor T1 in the connection controller 12_B shown in FIG. 9A and FIG. 9B, to turn on (ON) the first transistor T1 in the connection controller 12_B. A path between the driving group 11_A and the driving group 11_B is connected. The third signal end (3) of the DDIC inputs a low-voltage split-screen gating signal Sel2 to the gate of the second transistor T2 in the connection controller 12_B, to turn off (OFF) the second transistor T2 in the connection controller 12_B. The fourth signal end (4) of the DDIC inputs a low-voltage split-screen display signal STV_d_B, and the low-voltage split-screen display signal STV_d_B is used as an inactive non-start signal.

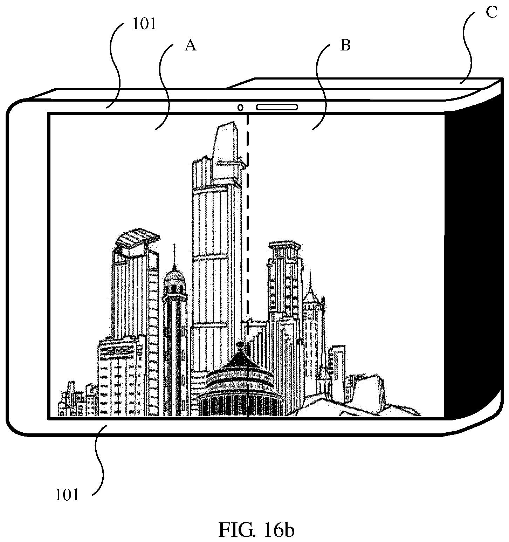

When a start signal STV is at a high voltage, the high voltage is provided as a start signal to a signal input end Iput of the first-level shift register SR1 in the driving group 11_A. Based on this, in an image frame, signal output ends Oput of all levels of shift registers SRs in the driving group 11_A input a light emitting control signal EM to the sub pixels 20 in the display subarea A column by column. Next, an active signal output by the signal output end Oput of the last-level shift register SR, for example, the SR640, in the driving group 11_A is used as a start signal and is transmitted to the signal input end Iput of the first-level shift register SR, for example, the SR641, in the driving group 11_B. Next, signal output ends Oput of all levels of shift registers SRs in the driving group 11_B input a light emitting control signal EM to the sub pixels 20 in the display subarea B column by column. In an image frame, as shown in FIG. 16b, the sub pixels 20 in the display subarea A and the display subarea B are scanned column by column in sequence from left to right, so that the display subarea A and the display subarea B jointly display the same image after the image frame ends.

In addition, to make the display subarea C not display an image, on one hand, the second signal end (2) of the DDIC inputs a low-voltage cascade gating signal Sell to a gate of the first transistor T1 in the connection controller 12_C, to turn off (OFF) the first transistor T1 in the connection controller 12_C. A path between the driving group 1 1_B and the driving group 11_C is disconnected. An active signal output by a signal output end Oput of a last-level shift register SR, for example, an SR1280, in the driving group 11_B cannot be transmitted to a signal input end Iput of a first-level shift register SR, for example, an SR1281, in the driving group 11_C.

On the other hand, the third signal end (3) of the DDIC inputs a high-voltage split-screen gating signal Sel2 to a gate of the second transistor T2 in the connection controller 12_C, to turn on (ON) the second transistor T2 in the connection controller 12_C. The fourth signal end (4) of the DDIC inputs a low-voltage split-screen display signal STV_d_C, and the low-voltage split-screen display signal STV_d_C is used as an inactive non-start signal. In this case, the display subarea C does not display an image.

In some other embodiments, the display subarea A does not perform displaying, and the display subarea B and the display subarea C jointly display a same image. Table 6 shows an on/off control status of transistors in connection controllers 12 and signals input by some signal ends.

**Table 6**

| Display subareas | T1 (12_B) | T2 (12_B) | T1 (12_C) | T2 (12_C) | STV | STV_d_B | STV_d_C |
|---|---|---|---|---|---|---|---|
| B+C | OFF | ON | ON | OFF | L | H | L |

The second signal end (2) of the DDIC inputs a low-voltage cascade gating signal Sell to the gate of the first transistor T1 in the connection controller 12_B, to turn off (OFF) the first transistor T1 in the connection controller 12_B. A path between the driving group 11_A and the driving group 11_B is disconnected. An active signal output by the signal output end Oput of the last-level shift register SR, for example, the SR640, in the driving group 11_A cannot be transmitted to the signal input end Iput of the first-level shift register SR, for example, the SR641, in the driving group 11_B. A start signal STV is at a low voltage and is used as an inactive non-start signal. In this case, the display subarea A does not display an image.

The third signal end (3) of the DDIC inputs a high-voltage split-screen gating signal Sel2 to the gate of the second transistor T2 in the connection controller 12_B, to turn on (ON) the second transistor T2 in the connection controller 12_B.

In addition, to enable the display subarea B and the display subarea C to jointly display a same image, the second signal end (2) of the DDIC inputs a high-voltage cascade gating signal Sell to a gate of the first transistor T1 in the connection controller 12_C, to turn on (ON) the first transistor T1 in the connection controller 12_C. The third signal end (3) of the DDIC inputs a low-voltage split-screen gating signal Sel2 to a gate of the second transistor T2 in the connection controller 12_C, to turn off (OFF) the second transistor T2 in the connection controller 12_C.

The fourth signal end (4) of the DDIC inputs a low-voltage split-screen display signal STV_d_C, and the low-voltage split-screen display signal STV_d_C is used as an inactive non-start signal, to prevent the fourth signal end (4) of the DDIC from staying in a floating (floating) state.

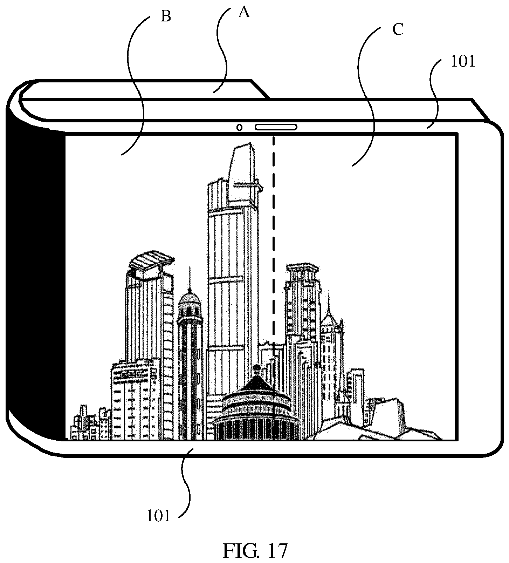

In this case, the driving group 11_B is cascaded to the driving group 11_C. A path is formed between the driving group 11_B and the driving group 11_C. As shown in FIG. 17, the display subarea A that does not display an image is bent to a back side of the display panel. In addition, the fourth signal end (4) of the DDIC inputs a high-voltage split-screen display signal STV_d_B, and the high voltage is provided as a start signal to the signal input end Iput of the first-level shift register SR in the driving group 11_B. Based on this, in an image frame, signal output ends Oput of all levels of shift registers SRs in the driving group 11_B input a light emitting control signal EM to the sub pixels 20 in the display subarea B column by column. Next, an active signal output by a signal output end Oput of a last-level shift register SR in the driving group 11_B is used as a start signal and is transmitted to a signal input end Iput of a first-level shift register SR in the driving group 11_C. Next, signal output ends Oput of all levels of shift registers SRs in the driving group 11_C input a light emitting control signal EM to the sub pixels 20 in the display subarea C column by column. In the image frame, the sub pixels 20 in the display subarea B and the display subarea C are scanned column by column in sequence from left to right, so that the display subarea B and the display subarea C jointly display the same image after the image frame ends.

In some other embodiments, the display subarea A and the display subarea C respectively display a first image and a second image, and the display subarea B does not perform displaying. Table 7 shows an on/off control status of transistors in connection controllers 12 and signals input by some signal ends. Control processes of the connection controllers 12 are the same as those described above. Details are not described herein again.

**Table 7**

| Display subareas | T1 (12_B) | T2 (12_B) | T1 (12_C) | T2 (12_C) | STV | STV_d_B | STV_d_C |
|---|---|---|---|---|---|---|---|
| A and C | OFF | ON | OFF | ON | H | L | H |

The second signal end (2) of the DDIC inputs a low-voltage cascade gating signal Sell to the gate of the first transistor T1 in the connection controller 12_B, to turn off (OFF) the first transistor T1 in the connection controller 12_B. A path between the driving group 11_A and the driving group 11_B is disconnected. When a start signal STV is at a high voltage, it can be learned by analogy that the display subarea A displays the first image.

The third signal end (3) of the DDIC inputs a high-voltage split-screen gating signal Sel2 to the gate of the second transistor T2 in the connection controller 12_B, to turn on (ON) the second transistor T2 in the connection controller 12_B. The fourth signal end (4) of the DDIC inputs a low-voltage split-screen display signal STV_d_B, and the low-voltage split-screen display signal STV_d_B is used as an inactive non-start signal. In addition, it can be learned from the foregoing description that the path between the driving group 11_A and the driving group 11_B is disconnected, and an active signal output by the signal output end Oput of the last-level shift register SR in the driving group 11_A cannot be transmitted to the signal input end Iput of the first-level shift register SR in the driving group 11_B. Therefore, the display subarea B does not display an image.

In addition, the second signal end (2) of the DDIC inputs a low-voltage cascade gating signal Sell to a gate of the first transistor T1 in the connection controller 12_C, to turn off (OFF) the first transistor T1 in the connection controller 12_C. A path between the driving group 11_B and the driving group 11_C is disconnected. An active signal output by a signal output end Oput of a last-level shift register SR in the driving group 11_B cannot be transmitted to a signal input end Iput of a first-level shift register SR in the driving group 11_C.

The third signal end (3) of the DDIC inputs a high-voltage split-screen gating signal Sel2 to a gate of the second transistor T2 in the connection controller 12_C, to turn on (ON) the second transistor T2 in the connection controller 12_C. The fourth signal end (4) of the DDIC inputs a high-voltage split-screen display signal STV_d_C. It can be learned by analogy that the display subarea C displays the second image.

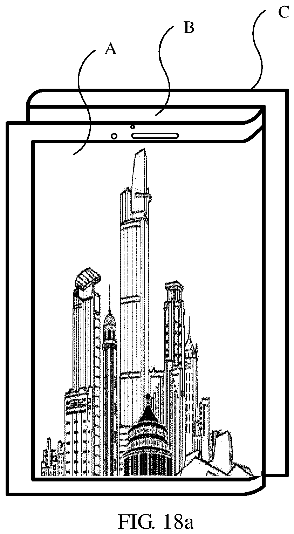

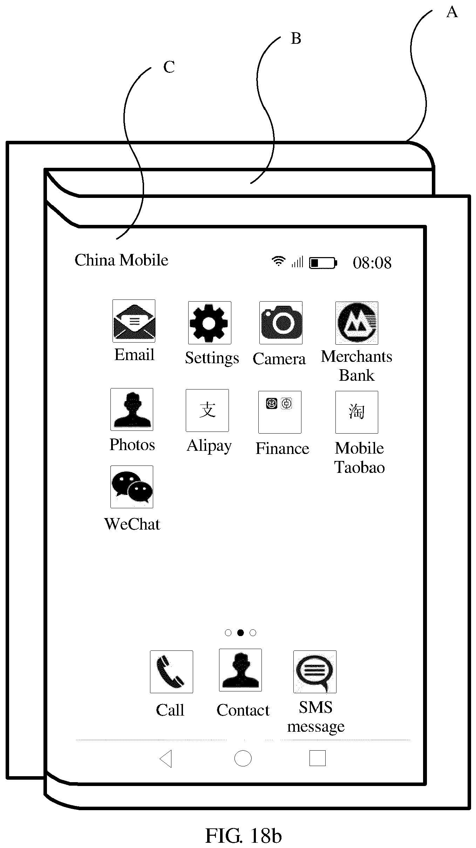

As shown in FIG. 18a and FIG. 18b, the display subarea B that does not display an image is folded between the display subarea A and the display subarea C. The display subarea A and the display subarea C are disposed opposite to each other. In this case, because the display subarea A and the display subarea C can perform displaying independently, the two display subareas may display different images. In this way, some users may see the image displayed in the display subarea A shown in FIG. 18a, and some other users may be located on a side opposite to the display subarea A and see the image displayed in the display subarea C shown in FIG. 18b.

### Example 4

In this example, only one of the display subarea A, the display subarea B, and the display subarea C in the active display area 100 of the OLED display panel displays an image, and the other display subareas do not perform displaying.

Based on this, when only the display subarea A displays an image, Table 8 shows an on/off control status of transistors in connection controllers 12 in the gate driving circuit 01 in FIG. 9A and FIG. 9B and signals input by some signal ends.

**Table 8**

| Display subareas | T1 (12_B) | T2 (12_B) | T1 (12_C) | T2 (12_C) | STV | STV_d_B | STV_d_C |
|---|---|---|---|---|---|---|---|
| A | OFF | ON | OFF | ON | H | L | L |

When the display subarea A performs displaying independently, the OLED display panel may use a folding manner shown in FIG. 18a.

In addition, the second signal end (2) of the DDIC inputs a low-voltage cascade gating signal Sell to the gate of the first transistor T1 in the connection controller 12_B shown in FIG. 9A and FIG. 9B, to turn off (OFF) the first transistor T1 in the connection controller 12_B. In this case, a path between the driving group 11_A and the driving group 11_B is disconnected. An active signal output by the signal output end Oput of the last-level shift register SR in the driving group 11_A cannot be transmitted to the signal input end Iput of the first-level shift register SR in the driving group 11_B. In this case, a start signal STV is at a high voltage, and as described above, the driving group 11_A controls the display subarea A to independently display an image.

The third signal end (3) of the DDIC inputs a high-voltage split-screen gating signal Sel2 to the gate of the second transistor T2 in the connection controller 12_B, to turn on (ON) the second transistor T2 in the connection controller 12_B. The fourth signal end (4) of the DDIC inputs a low-voltage split-screen display signal STV_d_B. In this case, because the second transistor T2 in the connection controller 12_B is turned on, and the fourth signal end (4) of the DDIC inputs the low-voltage split-screen display signal STV_d_B, the display subarea B does not display an image, and a floating state does not occur.

In addition, the second signal end (2) of the DDIC inputs a low-voltage cascade gating signal Sell to a gate of the first transistor T1 in the connection controller 12_C, to turn off (OFF) the first transistor T1 in the connection controller 12_C. In this case, a path between the driving group 11_B and the driving group 11_C is disconnected.

The third signal end (3) of the DDIC inputs a high-voltage split-screen gating signal Sel2 to a gate of the second transistor T2 in the connection controller 12_C, to turn on (ON) the second transistor T2 in the connection controller 12_C. The fourth signal end (4) of the DDIC inputs a low-voltage split-screen display signal STV_d_C, and the low-voltage split-screen display signal STV_d_C is used as an inactive non-start signal. In this case, the display subarea C does not display an image, and a floating state does not occur.

In some other embodiments, when only the display subarea C displays an image, Table 9 shows an on/off control status of transistors in connection controllers 12 in the gate driving circuit 01 in FIG. 9A and FIG. 9B and signals input by some signal ends. Control processes of the connection controllers 12 are the same as those described above. Details are not described herein again.

**Table 9**

| Display subareas | T1 (12_B) | T2 (12_B) | T1 (12_C) | T2 (12_C) | STV | STV_d_B | STV_d_C |
|---|---|---|---|---|---|---|---|
| C | OFF | ON | OFF | ON | L | L | H |

When the display subarea C performs displaying independently, the OLED display panel may use a folding manner shown in FIG. 18b.

The second signal end (2) of the DDIC inputs a low-voltage cascade gating signal Sell to the gate of the first transistor T1 in the connection controller 12_B shown in FIG. 9A and FIG. 9B, to turn off (OFF) the first transistor T1 in the connection controller 12_B. In this case, a path between the driving group 11_A and the driving group 11_B is disconnected. In this case, a start signal STV is at a low voltage, and the display subarea A does not display an image.

The third signal end (3) of the DDIC inputs a high-voltage split-screen gating signal Sel2 to the gate of the second transistor T2 in the connection controller 12_B, to turn on (ON) the second transistor T2 in the connection controller 12_B. The fourth signal end (4) of the DDIC inputs a low-voltage split-screen display signal STV_d_B. In this case, the display subarea B does not display an image, and a floating state does not occur.

In addition, the second signal end (2) of the DDIC inputs a low-voltage cascade gating signal Sell to a gate of the first transistor T1 in the connection controller 12_C shown in FIG. 9A and FIG. 9B, to turn off (OFF) the first transistor T1 in the connection controller 12_C in FIG. 9A and FIG. 9B. In this case, a path between the driving group 11_B and the driving group 11_C is disconnected.

The third signal end (3) of the DDIC inputs a high-voltage split-screen gating signal Sel2 to a gate of the second transistor T2 in the connection controller 12_C, to turn on (ON) the second transistor T2 in the connection controller 12_C. The fourth signal end (4) of the DDIC inputs a high-voltage split-screen display signal STV_d_C, and the high-voltage split-screen display signal STV_d_C is used as a start signal. In this case, the display subarea C displays an image independently.

In some other embodiments, when only the display subarea B displays an image, Table 10 shows an on/off control status of transistors in connection controllers 12 in the gate driving circuit 01 in FIG. 10 and signals input by some signal ends. Control processes of the connection controllers 12 are the same as those described above. Details are not described herein again.

**Table 10**

| Display subareas | T1 (12_B) | T2 (12_B) | T1 (12_C) | T2 (12_C) | STV | STV_d_B | STV_d_C |
|---|---|---|---|---|---|---|---|
| B | ON | ON | OFF | ON | L | H | L |

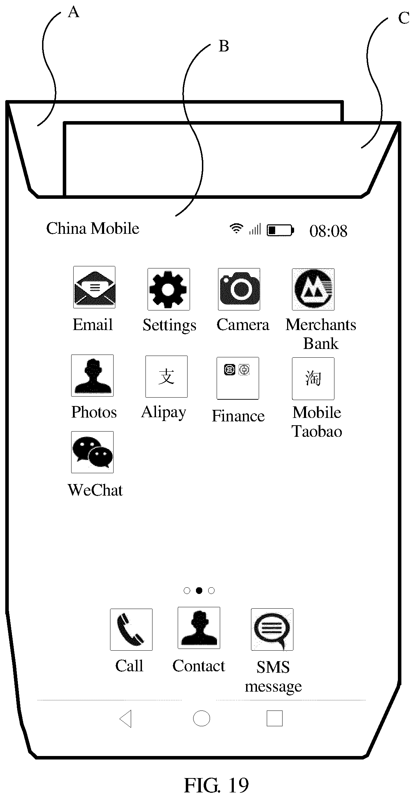

When the display subarea B displays independently, the OLED display panel may use a folding manner shown in FIG. 19.

The second signal end (2) of the DDIC inputs a low-voltage cascade gating signal Sell to the gate of the first transistor T1 in the connection controller 12_B shown in FIG. 9A and FIG. 9B, to turn off (OFF) the first transistor T1 in the connection controller 12_B. In this case, a path between the driving group 11_A and the driving group 11_B is disconnected. In this case, a start signal STV is at a low voltage, and the display subarea A does not display an image.

The third signal end (3) of the DDIC inputs a high-voltage split-screen gating signal Sel2 to the gate of the second transistor T2 in the connection controller 12_B, to turn on (ON) the second transistor T2 in the connection controller 12_B. The fourth signal end (4) of the DDIC inputs a high-voltage split-screen display signal STV_d_B. The display subarea B independently displays an image.

In addition, the second signal end (2) of the DDIC inputs a low-voltage cascade gating signal Sell to a gate of the first transistor T1 in the connection controller 12_C shown in FIG. 9A and FIG. 9B, to turn off (OFF) the first transistor T1 in the connection controller 12_C in FIG. 9A and FIG. 9B. In this case, a path between the driving group 11_B and the driving group 11_C is disconnected. An active signal output by a signal output end Oput of a last-level shift register SR in the driving group 11_B cannot be transmitted to a signal input end Iput of a first-level shift register SR in the driving group 11_C.

The third signal end (3) of the DDIC inputs a high-voltage split-screen gating signal Sel2 to a gate of the second transistor T2 in the connection controller 12_C, to turn on (ON) the second transistor T2 in the connection controller 12_C. The fourth signal end (4) of the DDIC inputs a low-voltage split-screen display signal STV_d_C. In this case, the display subarea C does not display an image, and a floating state does not occur.

It should be noted that in a process of bending the OLED display panel, the solutions for controlling some display subareas to perform displaying are described by using an example in which the OLED display panel displays an image by using a landscape mode. When the OLED display panel displays an image by using a portrait mode, the mobile terminal performs matching on an output display signal and a sub pixel arrangement manner based on an orientation of the screen, in other words, adjusts lateral and longitudinal dimensions of the displayed image. Manners of controlling the display subareas are the same as those described above. Details are not described herein again.

It can be learned from the foregoing description that the gate driving circuit 01 provided in the embodiments of this disclosure includes a plurality of driving groups 11, and different driving groups 11 respectively control different display subareas in the active display area 100 to perform displaying. In addition, a connection controller 12 is disposed between two adjacent driving groups 11. The connection controller 12 can cascade shift registers SRs in the two adjacent driving groups 11, so that after the cascading, two adjacent display subareas, for example, the display subarea A and the display subarea B, or the display subarea B and the display subarea C, controlled by the two adjacent driving groups 11 jointly display a same image in an image frame. Alternatively, the connection controller 12 may disconnect a path between two adjacent driving groups, for example, the driving group 11_A and the driving group_B, so that a lower-level driving group, for example, the driving group_B, connected to the connection controller 12 independently controls the display subarea B to independently display an image.

Based on this, when the gate driving circuit 01 is applied to a flexible display panel, the flexible display panel may be bent, so that a display area of the flexible display panel is reduced compared to an original display area. In this case, the reduced display area can still display a complete image independently.

Some embodiments of this application provide a method for controlling display of a gate driving circuit. The gate driving circuit 01 includes a first driving group (driving group 11_A), a first connection controller (connection controller 12_B), and a second driving group (driving group 11_B).

The first driving group (driving group 11_A) includes M cascaded shift registers SRs. An input end of the first driving group (driving group 11_A) is electrically connected to a first signal end (1) of a DDIC, where M ≥ 2, and M is a positive integer.

A first end of the first connection controller (connection controller 12_B) is electrically connected to an output end of the first driving group (driving group 11_A).

A second end of the first connection controller (connection controller 12_B) is electrically connected to a second signal end (2) of the DDIC.

A third end of the first connection controller (connection controller 12_B) is electrically connected to a third signal end (3) of the DDIC.

A fourth end of the first connection controller (connection controller 12_B) is electrically connected to a fourth signal end (4) of the DDIC.

The second driving group (driving group 11_A) includes N cascaded shift registers SRs, and an input end of the second driving group is electrically connected to a fifth end of the first connection controller (connection controller 12_B), where N ≥ 2, and N is a positive integer.

In addition, the connection controller 12 includes a first switch 1201 and a second switch 1202.

The first switch 1201 is electrically connected to the second signal end (2) of the DDIC; the output end of the first driving group, for example, a signal output end Oput of one level of shift register SR in the driving group 11_A; and the input end of the second driving group, for example, a signal input end Iput of one level of shift register SR in the driving group 11_B.

In some embodiments, the first switch 1201 may include the first transistor T1 shown in FIG. 9A and

FIG. 9B.

The second switch 1202 is electrically connected to the third signal end (3) of the DDIC, the fourth signal end (4) of the DDIC, and the input end of the second driving group, for example, a signal input end Iput of one level of shift register SR. In some embodiments, the second switch 1202 may include the second transistor T2 shown in FIG. 9A and FIG. 9B.

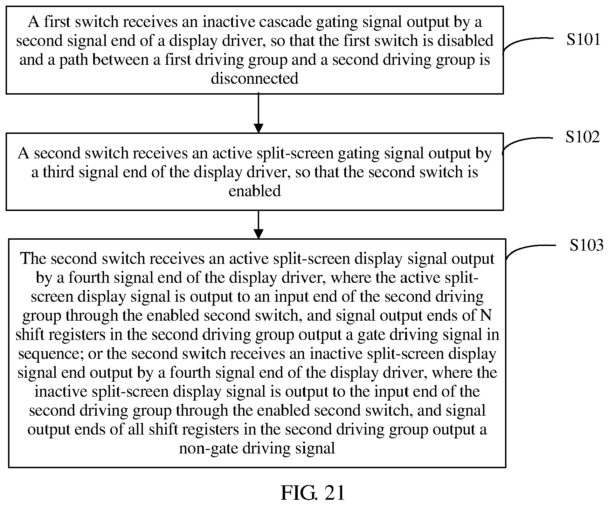

Based on this, as shown in FIG. 21, the method includes the following steps.

S101. The first switch 1201 receives an inactive cascade gating signal Sell output by the second signal end (2) of the DDIC, so that the first switch 1201 is disabled, and a path between the first driving group (driving group 11_A) and the second driving group (driving group 11_B) is disconnected.

When the first switch 1201 may include the first transistor T1 shown in FIG. 9A and FIG. 9B, S101 includes: inputting, by the second signal end (2) of the DDIC, a low voltage to a gate of the first transistor T1 in the connection controller 12_B, to turn off (OFF) the first transistor T1 in the connection controller 12_B. An active signal of a signal output end Oput of one level of shift register SR, for example, an SR640, in the first driving group (driving group 11_A) cannot be transmitted to a signal input end Iput of one level of shift register SR, for example, an SR641, in the second driving group (driving group 11_B), so that the path between the first driving group and the second driving group is disconnected.

S102. The second switch 1202 receives an active split-screen gating signal Sel2 output by the third signal end (3) of the DDIC, so that the second switch 1202 is enabled.

When the second switch 1202 includes the second transistor T2 shown in FIG. 9A and FIG. 9B, S102 includes: inputting, by the third signal end (3) of the DDIC, a high voltage to a gate of the second transistor T2 in the connection controller 12_B, to turn on (ON) the second transistor T2 in the connection controller 12_B.

S103. The second switch 1202 receives an active split-screen display signal STV_d output by the fourth signal end (4) of the DDIC. The active split-screen display signal STV_d is output to the input end of the second driving group (driving group 11_B) through the enabled second switch 1202. Signal output ends Oput of the plurality of shift registers SRs in the second driving group output a gate driving signal in sequence.

For example, the fourth signal end (4) of the DDIC inputs a high voltage, and the high voltage is provided as a start signal to the signal input end Iput of the first-level shift register SR641 in the driving group 11_B. Based on this, in an image frame, signal output ends Oput of all levels of shift registers SRs in the driving group 11_B input a gate driving signal, for example, a light emitting control signal EM, to sub pixels 20 in a display subarea B row by row. In this case, the display subarea B controlled by the driving group 11_B independently displays an image.

Alternatively, the second switch 1202 receives an inactive split-screen display signal STV_d output by the fourth signal end (4) of the DDIC. The inactive split-screen display signal STV_d is output to the input end of the second driving group (driving group 11_B) through the enabled second switch 1202. Signal output ends Oput of all shift registers SRs in the second driving group output a non-gate driving signal. In this case, the display subarea B controlled by the driving group 11_B does not display an image.

In some other embodiments, when the first driving group (driving group 11_A) includes a first-level shift register SR1 configured to receive a start signal STV, the method for controlling a gate driving circuit further includes:
providing an active start signal STV, for example, a high voltage, for a signal input end Iput of the first-level shift register SR1 in the first driving group (driving group 11_A), where signal output ends Oput of all levels of shift registers SRs in the first driving group (driving group 11_A) input a gate driving signal, for example, a light emitting control signal EM, to sub pixels 20 in a display subarea A row by row; and in this case, the display subarea A controlled by the first driving group (driving group 11_A) displays an image.

In this case, after S103 is performed, when the display subarea B also displays an image, the display subarea A and the display subarea B may respectively display a first image and a second image.

In some other embodiments, an active display area 100 further includes a display subarea C shown in FIG. 7b. The gate driving circuit 01 includes a driving group 11_C configured to control the display subarea C.

In this case, it can be learned from the foregoing description that, for the driving group 11-A and the driving group 11_B that are connected to the connection controller 12_B, the driving group 11-A is the first driving group and the driving group 11_B is the second driving group.

For the driving group 11_B and the driving group 11_C that are connected to a third connection controller (connection controller 12_C), the driving group 11-B is the second driving group, and the driving group 11_C is the third driving group. A control process of implementing path disconnection between the second driving group and the third driving group by using the third connection controller (connection controller 12_C) is the same as that described above. Details are not described herein again.

The foregoing descriptions are only specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A gate driving circuit, wherein the gate driving circuit is configured to drive a pixel circuit on a display panel to perform displaying, and the gate driving circuit comprises:
a first driving group, wherein the first driving group comprises M cascaded shift registers, and an input end of the first driving group is electrically connected to a first signal end of a display driver, to receive a start signal output by the first signal end of the display driver, wherein M ≥ 2, and M is a positive integer;
a first connection controller, wherein a first end of the first connection controller is electrically connected to an output end of the first driving group, to receive an active signal output by the first driving group; a second end of the first connection controller is electrically connected to a second signal end of the display driver, to receive a cascade gating signal output by the second signal end of the display driver; a third end of the first connection controller is electrically connected to a third signal end of the display driver, to receive a split-screen gating signal output by the third signal end of the display driver; and a fourth end of the first connection controller is electrically connected to a fourth signal end of the display driver, to receive a split-screen display signal output by the fourth signal end of the display driver; and
a second driving group, wherein the second driving group comprises N cascaded shift registers, and an input end of the second driving group is electrically connected to a fifth end of the first connection controller, to receive an active signal output by the fifth end of the first connection controller, wherein N ≥ 2, and N is a positive integer.

2. The gate driving circuit according to claim 1, wherein the gate driving circuit further comprises:
a second connection controller, wherein a first end of the second connection controller is electrically connected to an output end of the second driving group, to receive an active signal output by the second driving group; a second end of the second connection controller is electrically connected to the second signal end of the display driver, to receive the cascade gating signal output by the second signal end of the display driver; a third end of the second connection controller is electrically connected to the third signal end of the display driver, to receive the split-screen gating signal output by the third signal end of the display driver; and a fourth end of the second connection controller is electrically connected to the fourth signal end of the display driver, to receive the split-screen display signal output by the fourth signal end of the display driver; and
a third driving group, wherein the third driving group comprises S cascaded shift registers, and an input end of the third driving group is electrically connected to a fifth end of the second connection controller, to receive an active signal output by the fifth end of the second connection controller, wherein S ≥ 2, and S is a positive integer.

3. The gate driving circuit according to claim 1, wherein the first connection controller comprises a first switch and a second switch, wherein
the first switch is electrically connected to the second signal end of the display driver, the output end of the first driving group, and the input end of the second driving group; and the first switch is configured to receive the cascade gating signal output by the second signal end of the display driver and is enabled or disabled under control of the cascade gating signal, and in the enabled state, transmits, to the input end of the second driving group, the received active signal that is output by the output end of the first driving group; and
the second switch is electrically connected to the third signal end of the display driver, the fourth signal end of the display driver, and the input end of the second driving group; and the second switch is configured to receive the split-screen gating signal output by the third signal end of the display driver and is enabled or disabled under control of the split-screen gating signal, and in the enabled state, transmits, to the input end of the second driving group, the received split-screen display signal that is output by the fourth signal end of the display driver.

4. The gate driving circuit according to claim 3, wherein
the first switch comprises a first transistor, a gate of the first transistor is electrically connected to the second signal end of the display driver, a first electrode of the first transistor is electrically connected to the output end of the first driving group, and a second electrode of the first transistor is electrically connected to the input end of the second driving group; and
the second switch comprises a second transistor, a gate of the second transistor is electrically connected to the third signal end of the display driver, a first electrode of the second transistor is electrically connected to the fourth signal end of the display driver, and a second electrode of the second transistor is electrically connected to the input end of the second driving group.

5. The gate driving circuit according to claim 4, wherein in the first driving group or the second driving group, in a plurality of shift registers other than a first-level shift register, a signal output end of an upper-level shift register is electrically connected to a signal input end of a lower-level shift register;
the first electrode of the first transistor is electrically connected to a signal output end of a last-level shift register in the first driving group, and the second electrode of the first transistor is electrically connected to a signal input end of the first-level shift register in the second driving group; and
the second electrode of the second transistor is electrically connected to the signal input end of the first-level shift register in the second driving group.

6. A mobile terminal, wherein the mobile terminal comprises the gate driving circuit according to any one of claims 1 to 5, wherein
the mobile terminal further comprises a first pixel circuit and a second pixel circuit that are configured to display an image;
in a first driving group of the gate driving circuit, a signal output end of each level of shift register is electrically connected to gates of some transistors in the first pixel circuit; and
in a second driving group of the gate driving circuit, a signal output end of each level of shift register is electrically connected to gates of some transistors in the second pixel circuit.

7. The mobile terminal according to claim 6, wherein the pixel circuits each comprise a light emitting component and a light emitting control transistor that is in a turned-on state when the light emitting component emits light;
in the first driving group, a signal output end of each level of shift register is electrically connected to a gate of the light emitting control transistor in the first pixel circuit; and
in the second driving group, a signal output end of each level of shift register is electrically connected to a gate of the light emitting control transistor in the second pixel circuit.

8. The mobile terminal according to claim 6, wherein the mobile terminal comprises two gate driving circuits, which are respectively a first gate driving circuit and a second gate driving circuit, wherein
in the first gate driving circuit, a signal output end of each level of shift register in each first driving group is electrically connected to gates of some transistors in a first pixel circuit in an odd-numbered row or column; and a signal output end of each level of shift register in each second driving group is electrically connected to gates of some transistors in a second pixel circuit in an odd-numbered row or column; and
in the second gate driving circuit, a signal output end of each level of shift register in each first driving group is electrically connected to gates of some transistors in the first pixel circuit in an even-numbered row or column; and a signal output end of each level of shift register in each second driving group is electrically connected to gates of some transistors in the second pixel circuit in an even-numbered row or column.

9. The mobile terminal according to claim 6, wherein the display driver comprises a display driver integrated circuit, and the display driver integrated circuit comprises:
a first signal end, wherein the first signal end is configured to send a start signal;
a second signal end, wherein the second signal end is configured to send a cascade gating signal;
a third signal end, wherein the third signal end is configured to send a split-screen gating signal; and
a fourth signal end, wherein the fourth signal end is configured to send a split-screen display signal.

10. The mobile terminal according to any one of claims 6 to 9, wherein the mobile terminal further comprises an underlying substrate, and the first pixel circuit and the second pixel circuit are fabricated on the underlying substrate; and
a material constituting the underlying substrate comprises a flexible resin material.

11. A method for controlling a gate driving circuit, wherein the gate driving circuit comprises a first driving group, a first connection controller, and a second driving group; the first driving group comprises M cascaded shift registers, and an input end of the first driving group is electrically connected to a first signal end of a display driver, wherein M ≥ 2, and M is a positive integer; a first end of the first connection controller is electrically connected to an output end of the first driving group; a second end of the first connection controller is electrically connected to a second signal end of the display driver; a third end of the first connection controller is electrically connected to a third signal end of the display driver; a fourth end of the first connection controller is electrically connected to a fourth signal end of the display driver; and the second driving group comprises N cascaded shift registers, and an input end of the second driving group is electrically connected to a fifth end of the first connection controller, wherein N ≥ 2, and N is a positive integer;
the first connection controller comprises a first switch and a second switch; the first switch is electrically connected to the second signal end of the display driver, the output end of the first driving group, and the input end of the second driving group; and the second switch is electrically connected to the third signal end of the display driver, the fourth signal end of the display driver, and the input end of the second driving group; and
the method for controlling a gate driving circuit comprises:
receiving, by the first switch, an inactive cascade gating signal output by the second signal end of the display driver, so that the first switch is disabled and a path between the first driving group and the second driving group is disconnected;
receiving, by the second switch, an active split-screen gating signal output by the third signal end of the display driver, so that the second switch is enabled;
receiving, by the second switch, an active split-screen display signal output by the fourth signal end of the display driver, wherein the active split-screen display signal is output to the input end of the second driving group through the enabled second switch, and signal output ends of the N shift registers in the second driving group output a gate driving signal in sequence; or receiving, by the second switch, an inactive split-screen display signal end output by the fourth signal end of the display driver, wherein the inactive split-screen display signal is output to the input end of the second driving group through the enabled second switch, and signal output ends of all the shift registers in the second driving group output a non-gate driving signal.

12. The method for controlling a gate driving circuit according to claim 11, wherein the method further comprises:
receiving, by the input end of the first driving group, an active start signal output by the first signal end of the display driver, wherein signal output ends of all levels of shift registers in the first driving group output gate driving signals in sequence.
